# DEMANDE DE BREVET EUROPEEN

(11) **EP 4 561 293 A1**
(43) Date de publication de la demande: **28.05.2025**
(21) Numéro de dépôt: 24214628.0
(22) Date de dépôt: 21.11.2024
(51) Int. Cl.: H10D 48/00, H10D 62/17, H10D 62/81, H10D 62/10, H10D 30/40, H10D 64/27, B82Y 10/00

(54) **DISPOSITIFS QUANTUMIQUES COMPRENANT UNE MATRICE DE BOÎTES QUANTIQUES ET DES DÉTECTEURS DE CHARGE INTÉGRÉS, AINSI QUE MÉTHODE DE FABRICATION DE CES DISPOSITIFS**

(30) Priorité: 21.11.2023 FR 2312796
(71) Demandeur: Commissariat à l'Energie Atomique et aux Energies Alternatives, 75015 Paris (FR)
(72) Inventeur: BERTRAND, Benoit, 38054 GRENOBLE CEDEX 09 (FR)
(74) Mandataire: Cabinet Camus Lebkiri

(57) **Abrégé**

Un aspect de l'invention concerne un dispositif quantique (100) comprenant :
- Une couche semiconductrice (110) adaptée pour former une matrice bidimensionnelle (115) de boites quantiques (1151), la couche semiconductrice (110) présentant une face avant (110a),
- un diélectrique (120), disposé sur la face avant (110a) de la couche semiconductrice (110),
- Des premières lignes de grilles (131) et des deuxièmes lignes de grilles (132) pour contrôler les boîtes quantiques (1151), les premières lignes de grilles (131) et les deuxièmes lignes grilles (132) s'étendant directement sur le diélectrique (120), chaque deuxième ligne de grilles (132) croisant les premières lignes de grilles (131),
- des détecteurs de charges (140), chaque détecteur de charge (140) comprenant un ilot conducteur (141), une source (143) et un drain (142), l'ilot conducteur (141) de chaque détecteur de charge (140) étant formé entre deux premières grilles (131) adjacentes et directement sur le diélectrique (120).

## Description

### DOMAINE TECHNIQUE DE L'INVENTION

Le domaine technique de l'invention est celui de l'électronique quantique et plus particulièrement des dispositifs électroniques quantiques et de la fabrication de ces derniers.

### ARRIERE-PLAN TECHNOLOGIQUE DE L'INVENTION

L'utilisation d'états quantiques à deux niveaux mesurables comme vecteur d'information, également appelés "qubits" pour "quantum bits" en anglais, et des lois de la mécanique quantique (superposition, intrication, mesure) offre la possibilité de développer des algorithmes quantiques surpassant en performances certaines classes d'algorithmes classiques. Pour les implémenter, des milliers de qubits sont requis. Enfin, trois types d'opérations doivent pouvoir être effectuées sur les qubits : l'initialisation dans un état connu, la manipulation (portes logiques sur un ou plusieurs qubits), et la lecture de ces qubits.

Les technologies semi-conductrices à même de permettre la manipulation de qubits comprennent des îlots, également appelés boîtes quantiques, réalisés dans des structures de confinement de tailles nanométriques définies par exemple de manière électrostatique au sein d'une couche semiconductrice. Les boites quantiques assurent le confinement de charges élémentaires, électrons ou trous, et l'information quantique est, par exemple, codée sur le spin de ces particules.

Pour qu'une boite quantique soit initialisée par exemple avec un électron ou un trou unique, elle doit être couplée à une électronique de lecture capable de déterminer le nombre de charge dans la boite quantique.

L'utilisation de dispositifs supplémentaires couplés à une électronique de lecture, tels que des détecteurs de charge mesurés en courant ou en réflectométrie, permet de réaliser une détection du nombre de charge plus efficace que des méthodes de détection in-situ.

Les transistors à un électron SET (acronyme de « single Electron Transistor » en anglais) font partie des détecteurs de charge les plus efficaces.

En général, un SET comprend un îlot quantique, deux réservoirs de charge, aussi appelés drain et source, et un contact de grille.

L'ilot quantique est relié à chacun des réservoirs par au moins une jonction, par exemple une jonction tunnel, ou couplage tunnel.

Les réservoirs de charge (drain et source) sont considérés comme des matériaux métalliques massifs dont les électrons obéissent à la statistique de Fermi-Dirac, et l'îlot est par exemple un grain de métal dont la taille est de quelques nanomètres. Le contact de grille est typiquement séparé de l'îlot par une couche de matériau diélectrique. La jonction tunnel est par exemple réalisée par une autre couche de matériau diélectrique, dite jonction tunnel, agencée de sorte à séparer l'ilot des réservoirs de charge.

Une ou plusieurs électrodes sont par ailleurs connectées aux réservoirs de charge et au contact de grille pour appliquer une tension sur ces éléments.

Le fonctionnement des SET repose sur un couplage capacitif avec la boite quantique, un changement du nombre de charges dans cette dernière pouvant par exemple affecter l'impédance du SET.

Cette détection, ou lecture, de la charge résultante est généralement effectuée en courant (en transport) ou par réflectométrie avec l'utilisation d'un résonateur LC.

Lorsque le SET est lu en courant, son drain et sa source sont polarisés indépendamment l'un de l'autre. Dit autrement, deux réservoirs de charge indépendants (source et drain) sont nécessaires. Lorsque le SET est lu par réflectométrie, son drain et sa source sont polarisables au même potentiel, et un seul réservoir de charge (drain ou source) est nécessaire.

L'intégration des SET au plus près des qubits serait avantageuse pour améliorer la sensibilité de la détection. Or, les SETs, et particulièrement les SETs lus en courant, sont coûteux en termes d'encombrement du fait du nombre important d'éléments qui les constituent. Leur intégration dans le plan des qubits réduit le nombre de qubits pouvant y être intégrés par unité de surface, ou/et nécessite des interactions à plus longue portée entre qubits voisins pour permettre une interconnectivité à au moins 4 plus proches voisins.

A défaut d'un mécanisme permettant une interaction à longue portée entre qubits, les SETs sont généralement intégrés en périphérie de matrice de boites quantiques. L'inconvénient est que la taille de cette matrice doit être réduite à quelques boites quantiques par côté pour permettre de lire les qubits disposés au centre de la matrice.

Il est par ailleurs proposé d'intégrer et de connecter les détecteurs de charges dans des plans différents du plan comprenant les boîtes quantiques. On parle dans ce cas de circuits à architecture non-planaire, dite également "3D" pour "à 3 dimensions".

La demande de brevet FR 3 066 297 propose ainsi un circuit électronique quantique à contrôle parallèle comprenant une couche semiconductrice recevant une matrice de qubits, un réseau d'électrodes disposé de chaque côté de cette couche semiconductrice, et un plan empilé sur la couche semiconductrice comprenant une matrice de détecteurs de charge. Ainsi, chaque niveau, ou chaque plan, du dispositif quantique est dédié à une fonction spécifique.

Cette solution présente l'avantage que chaque qubit est relié à au moins un détecteur de charge situé à l'aplomb de celui-ci, cela quel que soit le qubit considéré dans la matrice.

Toutefois, l'architecture de ce circuit est particulièrement complexe, notamment du fait de la forte densité de vias et d'interconnexions requis pour relier les différents plans du dispositif. De ce fait, certaines étapes de fabrication peuvent être difficiles à réaliser.

Ainsi, il n'existe actuellement pas de solution satisfaisante pour intégrer des SETs dans des circuits électroniques quantiques 2D de haute densité. Il reste ainsi un besoin d'une solution d'intégration de détecteurs de charge mesurés en transport dans des matrices de boites quantiques bidimensionnelles, qui permette un bon couplage capacitif entre ces détecteurs de charge et ces boites quantiques tout en étant simple à mettre en oeuvre.

### RESUME DE L'INVENTION

La présente invention offre une solution aux problèmes évoqués précédemment en permettant de réduire, sur la puce électronique, l'encombrement et la complexité de détecteurs de charge lus en courant.

Plus particulièrement, un premier aspect de l'invention propose un dispositif quantique comprenant :
- Une couche semiconductrice adaptée pour former une matrice bidimensionnelle de boites quantiques, la couche semiconductrice présentant une face avant,
- Un diélectrique, disposé sur la face avant de la couche semiconductrice,
- Des premières grilles et des deuxièmes grilles pour contrôler les boîtes quantiques, les premières grilles et les deuxièmes grilles s'étendant directement sur le diélectrique, chaque deuxième grille croisant les premières grilles, les premières et deuxièmes grilles définissant un réseau de mailles bidimensionnelles, chaque maille bidimensionnelle étant en regard d'une boite quantique,
- Des détecteurs de charges, chaque détecteur de charge comprenant un ilot conducteur, une source et un drain,
l'ilot conducteur de chaque détecteur de charge étant formé au niveau d'une maille bidimensionnelle, entre deux premières grilles adjacentes et directement sur le diélectrique.

Ainsi, de manière avantageuse selon l'invention, l'îlot conducteur de chaque détecteur de charge est formé au même niveau que celui des premières et deuxièmes grilles (l'expression « même niveau » signifie ici entre la face inférieure et la face supérieure des premières grilles). Cela permet d'obtenir un dispositif quantique compact (en termes de hauteur). Cela permet, aussi, d'obtenir un dispositif quantique qui n'utilise qu'un seul substrat semiconducteur et dont la fabrication ne fait appel à des étapes de collage.

De plus, grâce à l'îlot conducteur qui est posé sur le diélectrique dans une maille bidimensionnelle, il y a un bon couplage capacitif entre la boite quantique formée à l'aplomb de la maille bidimensionnelle et les boites quantiques voisines. Cette proximité améliore la sensibilité de la détection du dispositif quantique. Il convient d'ajouter que le fait de former les îlots conducteurs entre des premières grilles offre l'avantage de pouvoir utiliser ces premières grilles comme repère d'alignement au moment des étapes de fabrication des îlots conducteurs. Dit autrement, les premières grilles permettent d'« auto-aligner» les îlots conducteurs. Cet auto-alignement facilite ces étapes de fabrication.

Le dispositif quantique selon l'invention offre ainsi une solution d'intégration compatible avec les procédés de fabrication industriels et l'intégration de boites quantiques à large échelle, tout en permettant la proximité requise entre les détecteurs de charge lus en courant et les boites quantiques.

Outre les caractéristiques qui viennent d'être évoquées dans le paragraphe précédent, le dispositif quantique selon le premier aspect de l'invention peut présenter une ou plusieurs caractéristiques complémentaires parmi les suivantes, considérées individuellement ou selon toutes les combinaisons techniquement possibles :
- l'ilot conducteur de chaque détecteur de charges est intégré dans l'une des deuxièmes lignes de grilles
- le drain de chaque détecteur de charge comprend un via conducteur enrobé d'un matériau électriquement isolant, le via conducteur enrobé présentant une extrémité disposée au contact d'une couche barrière disposée à l'aplomb de l'îlot conducteur dudit détecteur de charge.
- l'ilot conducteur de chaque détecteur de charge est formé dans une grille de contrôle des boites quantiques distincte des premières grilles, ladite grille croisant les premières grilles et s'étendant directement sur le diélectrique, ladite grille présentant des renfoncements isolants recouverts d'une couche électriquement isolante, les renfoncements isolants étant disposés aux croisements de ladite grille avec les premières grilles, chaque renfoncement isolant abritant une première grille, les renfoncements isolants définissant dans ladite grille une pluralité de régions conductrices inférieures s'étendant directement sur le diélectrique, et une région conductrice supérieure continue.
- ladite grille est une des deuxièmes grilles.
- Alternativement, ladite grille est une troisième grille d'un ensemble de troisièmes grilles destinées à contrôler le potentiel chimique des boites quantiques, chaque troisième grille étant disposée à l'aplomb des boites quantiques formées le long d'une colonne ou d'une diagonale de la matrice de boites quantiques
- Ladite grille présente une structure interne d'un premier type comprenant :
   - une couche tunnel recouvrant chaque renfoncement isolant de ladite grille,
   - une région conductrice inférieure sur quatre prolongeant la région conductrice supérieure vers le diélectrique, ladite région conductrice inférieure sur quatre définissant trois régions conductrices inférieures complémentaires,
   - les deux régions conductrices inférieures situées aux extrémités des trois régions inférieures complémentaires étant recouvertes d'une couche barrière supérieure, la couche barrière supérieure étant disposée sur les couches tunnel,
   - la région conductrice inférieure située au centre des trois régions conductrices inférieures complémentaires est prolongée par un via conducteur enrobé d'un matériau électriquement isolant, ledit via conducteur traversant la région supérieure jusqu'à la couche barrière supérieure.
- une deuxième grille sur deux, ou une troisième grille sur deux, peut alors présenter la structure interne du premier type.
- les ilots conducteurs sont disposés alors en quinconce les uns par rapport aux autres.
- Alternativement, chaque deuxième grille, ou chaque troisième grille, peut présenter la structure interne du premier type.
- Alternativement à la structure du premier type, ladite grille présente une structure interne d'un deuxième type comprenant :
   - Une couche barrière recouvrant toutes les régions conductrices inférieures de ladite grille, la couche barrière étant continue et disposée sur les renfoncements isolants de ladite grille,
   - Des vias conducteurs enrobés d'un matériau électriquement isolant traversant la région conductrice supérieure jusqu'à la couche barrière, chaque via conducteur présentant une extrémité disposée, pour une partie, à l'aplomb d'une région conductrice inférieure et, pour l'autre partie, à l'aplomb d'un renfoncement isolant adjacent à ladite région conductrice inférieure,
- une deuxième grille sur deux, ou une troisième grille sur deux, peut alors présenter la structure interne du deuxième type.
- Alternativement, chaque deuxième grille, ou chaque troisième grille, peut présenter la structure interne du deuxième type.
- Le dispositif quantique peut comprendre des grilles d'adressage pour adresser les drains des détecteurs de charge, chaque grille d'adressage étant couplée aux vias conducteurs situés sur une même colonne de la matrice de boites quantiques.
- Lorsque ladite grille présente la structure interne du premier ou du deuxième type, la région supérieure de ladite grille est couplée à une source de tension pour adresser les sources des détecteurs de charges formés dans ladite grille.
- le dispositif quantique peut comprendre des grilles de contrôle des potentiels chimiques des ilots conducteurs, chaque grille de contrôle s'étendant sur une des premières grilles et étant logée sous les renfoncements isolants des deuxièmes grilles au niveau des croisements des premières et deuxièmes grilles.
- la couche semiconductrice comprend des trous pour former les boites quantiques,
- Les trous étant disposés à l'aplomb des croisements entre les premières et deuxièmes grilles.

Un deuxième aspect de l'invention concerne un procédé de fabrication d'un dispositif quantique comprenant des détecteurs de charge, chaque détecteur de charge comprenant un îlot conducteur, un drain et une source, le procédé comprenant les étapes suivantes :
- Fourniture d'une couche semiconductrice adaptée pour former une matrice bidimensionnelle de boites quantiques, ladite couche semiconductrice présentant une face avant, ladite couche semiconductrice comprenant un diélectrique disposé sur la face avant et des premières grilles pour contrôler les boites quantiques, les premières grilles s'étendant directement sur le diélectrique,
- Enrobage des flancs et de la face supérieure de chaque première grille pour loger chaque première grille sous un renfoncement isolant,
- Définition des îlots conducteurs à partir des premières grilles enrobées, chaque ilot conducteur s'étendant entre deux premières grilles adjacentes et directement sur le diélectrique,
- Formation, à partir des îlots conducteurs définis, de deuxièmes grilles pour contrôler, avec les premières grilles, les boites quantiques, chaque deuxième grille s'étendant directement sur le diélectrique et croisant les premières grilles, les premières et deuxièmes grilles formant un réseau de mailles bidimensionnelles sur le diélectrique.

De préférence, l'étape de définition des îlots conducteurs peut comprendre les sous-étapes suivantes :
- Remplissage avec un matériau conducteur des espaces du diélectrique délimités par deux premières grilles adjacentes enrobées, le remplissage s'arrêtant à la hauteur des renfoncements isolants,
- Formation d'une couche barrière sur toute la surface obtenue après le remplissage,
- Structuration de la couche barrière pour former des bandes barrières orientées avec un angle prédéterminé par rapport aux premières grilles.

De préférence, l'angle prédéterminé est tel que les bandes barrières sont orientées à 45° par rapport à la direction des premières grilles, les bandes barrières s'étendant, dans la direction perpendiculaire aux premières grilles, sur quatre bandes conductrices adjacentes.

De préférence, le procédé de fabrication peut comprendre, après l'étape de formation des deuxièmes grilles, une étape de réalisation de vias conducteurs enrobés d'un matériau électriquement isolant, chaque via conducteur traversant une région supérieure d'une des deuxièmes grilles avec arrêt sur une région d'une bande diélectrique barrière, le via conducteur formant le drain de l'ilot conducteur défini à l'aplomb de la région de la bande barrière.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
- La figure 1 montre une représentation schématique en vue de dessus d'un dispositif quantique selon un premier mode de réalisation de l'invention,
- La figure 2 montre une représentation schématique en vue de coupe du dispositif quantique représenté sur la figure 1,
- La figure 3A montre une première représentation schématique en perspective d'une partie du dispositif quantique représenté sur la figure 1,
- La figure 3B montre une deuxième représentation schématique en perspective d'une partie du dispositif quantique représenté sur la figure 1,
- La figure 3C montre une troisième représentation schématique en perspective d'une partie du dispositif quantique représenté sur la figure 1,
- La figure 4 montre une représentation schématique en vue de coupe d'un dispositif quantique alternatif au dispositif quantique représenté sur la figure 1, permettant de former autant de détecteurs de charge que de boites quantiques,
- La figure 5 représente schématiquement en vue de dessus un dispositif quantique alternatif au dispositif quantique représenté sur la figure 1, permettant de positionner les détecteurs de charge à l'aplomb des boites quantiques,
- La figure 6 représente schématiquement en vue de dessus un dispositif quantique alternatif au dispositif quantique représenté sur la figure 5,
- La figure 7 est un schéma synoptique illustrant l'enchaînement des étapes d'un procédé de fabrication du dispositif quantique représenté sur la figure 1,
- La figure 8 est un schéma synoptique illustrant un mode de mise en oeuvre préférentiel du procédé de fabrication de la figure 8,
- La figure 9 est un schéma synoptique illustrant un mode de mise en oeuvre préférentiel du procédé de fabrication de la figure 8,
- La figure 10 est un schéma synoptique illustrant un mode de mise en oeuvre préférentiel du procédé de fabrication de la figure 8,
- Les figures 11A à 11L illustrent les étapes ou sous-étapes du procédé de fabrication représenté sur la figure 7, chaque figure montrant une vue en perspective et une vue de coupe d'une des étapes ou sous-étapes.

Sauf précision contraire, un même élément apparaissant sur des figures différentes présente une référence unique.

### DESCRIPTION DETAILLEE

La présente invention se place dans le contexte des dispositifs électroniques quantiques et de leur procédé de fabrication. Plus particulièrement, l'invention vise à permettre, via des détecteurs de charge lus en transport, une détection efficace de l'état de charge des boites quantiques formées sur les dispositifs quantiques. En particulier, encore, l'invention vise à réduire l'espace occupé par ces détecteurs de charge sur le dispositif quantique pour offrir une architecture permettant de réaliser des qubits de spin à grande échelle.

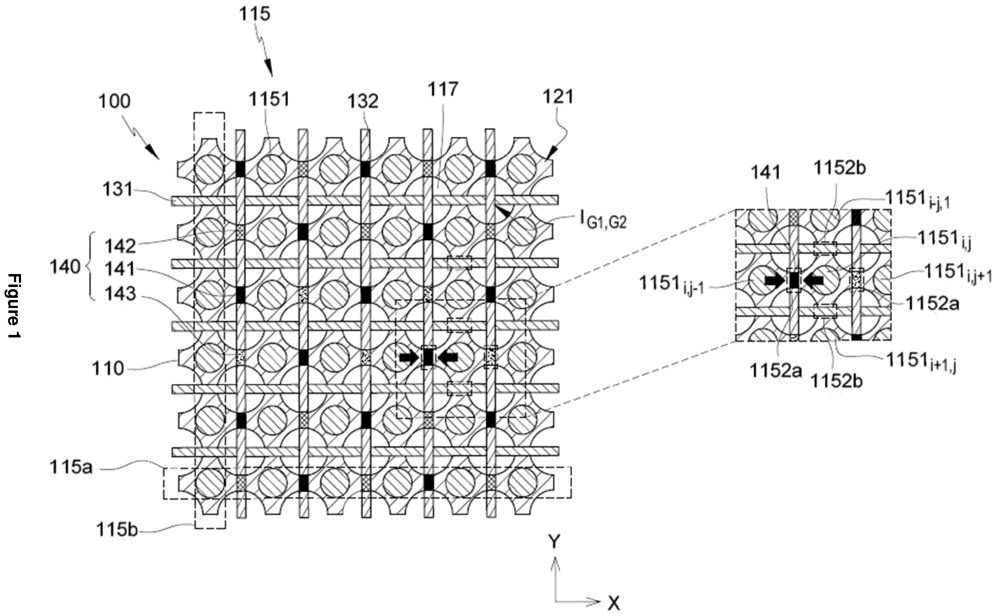

Les figures 1, 2, 3 et 4 représentent, sous une forme schématique, un dispositif quantique 100 (aussi noté « dispositif 100 » par la suite) selon un premier mode de réalisation

La figure 1 montre, sous forme schématique, une vue de dessus d'une partie du dispositif quantique 100 selon ce premier mode de réalisation.

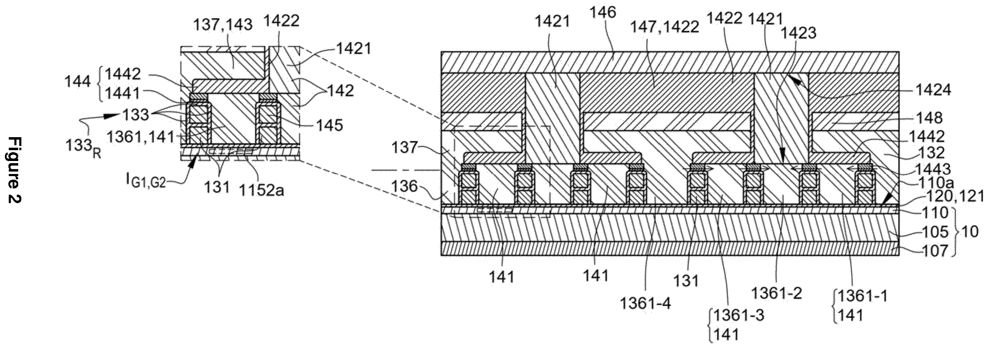

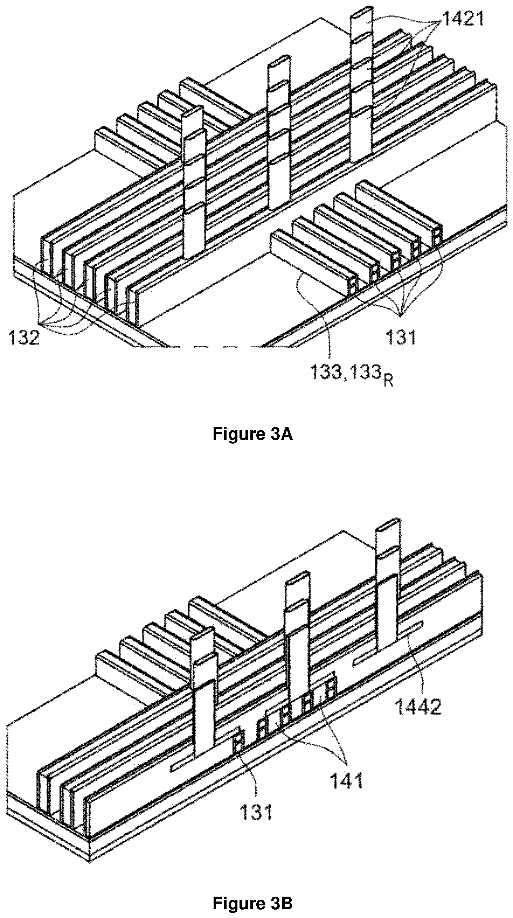

La figure 2 et les figures 3A à 3C montrent respectivement une vue de coupe transversale et une vue en perspective d'une première variante de réalisation du dispositif quantique 100 représenté sur la figure 1.

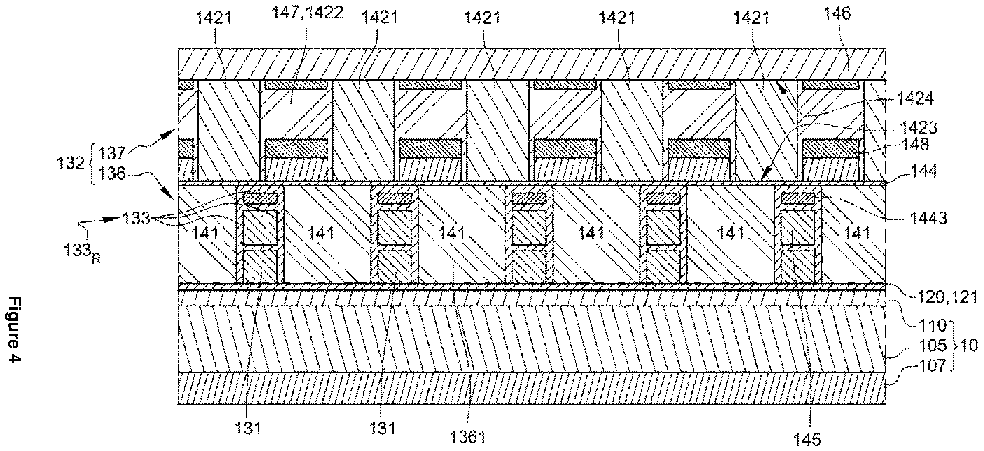

La figure 4 montre une vue de coupe transversale, selon un même plan de coupe que celui de la figure 2, d'une deuxième variante de réalisation du dispositif quantique 100 de la figure 1.

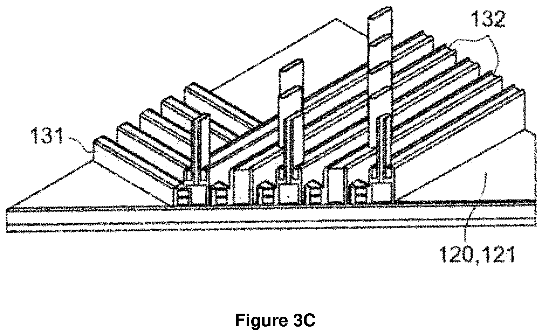

En référence à la figure 1, et de manière commune aux deux variantes de réalisation illustrées en figures 2, 3 et en figure 4, le dispositif quantique 100 s'étend dans un plan {X,Y} et est formé à partir d'une couche semiconductrice 110. Le dispositif 100 comprend en outre un diélectrique 121, des premières et deuxièmes grilles 131, 132 et des détecteurs de charge 140. Typiquement, les premières grilles et les deuxièmes grilles sont des grilles de couplage. Ces éléments sont décrits en détail ci-après.

Dans la suite de la description, les termes « épaisseur » ou « hauteur » désignent des dimensions mesurées perpendiculairement au plan {X ; Y}. L'expression « dimension latérale » désigne une dimension mesurée dans le plan {X ;Y}.

Il est noté que le terme « grille » peut être utilisé ici pour désigner une ligne de grilles. On entend par « ligne de grilles » une ligne comportant une pluralité de grilles.

**La couche semiconductrice 110** présente une face avant 110a, illustrée en figure 2.

La couche semiconductrice 110 est adaptée pour former une matrice 115 de boites quantiques 1151. Dit autrement, la couche semiconductrice 110 présente des caractéristiques permettant de former une matrice 115 de boîtes quantiques 1151 en son sein. Ces boites quantiques sont représentées par des cercles hachurés sur la figure 1.

Le terme « matrice » désigne ici un arrangement des boites quantiques selon des lignes 115a et des colonnes 115b (cf. figure 1).

En référence à la figure 2 ou aux figures 3A à 3C, la couche semiconductrice 110 présente une épaisseur comprise entre 5 nm et 35 nm et de manière préférée entre 10 nm et 20 nm, par exemple égale à 15 nm.

La couche semiconductrice 110 est de préférence une couche de silicium 110.

De préférence, cette couche de silicium 110 est issue d'un substrat 10 de type silicium sur isolant ou SOI (acronyme de « Silicium On insulator » en anglais).

Un tel substrat 10 est illustré sur la figure 2. Il comprend un empilement, du bas vers le haut, d'une couche semiconductrice massive 107, d'une couche isolante 105, et de la couche semiconductrice 110 de silicium. La couche isolante 105 est disposée entre la couche semiconductrice massive 107 et la couche semiconductrice 110. La polarisation d'un tel substrat 10 permet de contrôler électro-statiquement le confinement de charges dans la couche semiconductrice 110 et offre donc un niveau de contrôle de potentiel supplémentaire pour le dispositif 100.

La couche semiconductrice 110 peut, alternativement, être une couche de silicium massive.

La couche semiconductrice 110 peut, alternativement, être une hétérostructure semiconductrice comprenant un puit quantique ou un gaz d'électrons bidimensionnel (2DEG). De telles structures présentent des interfaces avec de faibles densités de défauts, facilitant le confinement des charges et leur contrôle électrostatique.

La couche semiconductrice 110 peut avantageusement présenter des trous 117. Ces trous 117 sont illustrés par des cercles blancs sur la figure 1. Ces trous 117 peuvent être par exemple obtenus par gravure de la couche semiconductrice 110.

Les trous 117 sont préférentiellement arrangés en lignes et en colonnes pour former une matrice de trous 117. Sur la figure 1, les lignes de trous 117 sont orientées dans une première direction X correspondant à la direction des lignes 115a de boites quantiques 1151. De manière analogue, les colonnes de trous 117 sont orientées dans une deuxième direction Y correspondant à la direction des colonnes 115b de boites quantiques 1151.

Les trous 117 sont disposés entre les lignes et les colonnes de boites quantiques. Préférentiellement, comme illustré sur la figure 1, quatre trous 117 encadrent chaque zone correspondant à une boite quantique 1151.

Le diamètre des trous 117 est préférentiellement compris entre 20 nm et 50 nm. Ainsi, les trous 117 structurent la couche semiconductrice 110 pour confiner des charges dans chaque zone non gravée, c'est-à-dire dans la zone correspondant à la boite quantique 1151. La présence des trous 117 facilite ainsi la formation des boites quantiques 1151.

Le diélectrique 121 est disposé sur la face avant 110a de la couche semiconductrice 110 et est formé d'une ou de plusieurs couches, chaque couche étant formée d'un matériau diélectrique (cf. figure 2, figures 3A à 3C, ou figure 4).

Préférentiellement, comme le montre la figure 2, le diélectrique 121 est constitué d'une seule couche 120 de diélectrique qui recouvre la face avant 110a de la couche semiconductrice 110. La couche 120 de diélectrique présente une épaisseur préférentiellement comprise entre 5 nm et 10 nm et est électriquement isolant. La couche 120 de diélectrique est par exemple en oxyde de silicium (SiO2).

Selon une variante, non représentée par les figures, la couche 120 de diélectrique peut être partiellement recouverte, c'est-à-dire recouverte entre les premières grilles 131, par une autre couche de diélectrique, dite « seconde couche de diélectrique ». Selon cette variante, le diélectrique 121 est alors constitué de la couche 120 de diélectrique et de la seconde couche de diélectrique recouvrant cette couche 120 de diélectrique. La seconde couche de diélectrique peut alors être formée de SiO₂ ou d'un oxyde d'aluminium (Al₂O₃). L'épaisseur maximale de la seconde couche de diélectrique dépend du matériau choisi : lorsque le matériau est du SiO₂, l'épaisseur est par exemple de 5 nm ; lorsque le matériau est de l'AL₂O₃, l'épaisseur maximale de la couche espaceur peut être comprise entre 10 nm et 15 nm.

**Les premières grilles 131 et des deuxièmes grilles 132** sont des bandes conductrices formées à base d'un matériau conducteur choisi parmi les matériaux suivants : silicium cristallin dopé (ou Poly-Si dopé), tungstène (W), nitrure de titane (TiN).

**Les premières grilles 131** s'étendent entièrement sur la couche 120 de diélectrique du diélectrique 121, selon une première direction X, illustrée en figure 1, qui correspond à l'orientation des lignes 115a de boites quantiques 1151.

Chaque première grille 131 présente une section dont la hauteur est préférentiellement comprise entre 5 nm et 50 nm, et de préférence égale à 25 nm. La dimension latérale et la hauteur de la section sont de préférence sensiblement identiques. La section de chaque première grille 131 est alors une section carrée.

Chaque première grille 131 est en outre recouverte, ou enrobée, sur ses flancs (c'est-à-dire ses faces latérales) et sa face supérieure (c'est-à-dire la face opposée à la couche 120 de diélectrique) d'une couche espaceur 133 (cf. figure 2). Cette couche espaceur 133 est formée d'un matériau diélectrique, par exemple de SiO₂ ou d'Al₂O₃. Son épaisseur maximale dépend du matériau choisi : lorsque le matériau est du SiO₂, l'épaisseur est par exemple de 5 nm ; lorsque le matériau est de l'AL₂O₃, l'épaisseur maximale de la couche espaceur peut être comprise entre 10 nm et 15 nm.

Lorsque le diélectrique 121 est formé de la couche 120 de diélectrique et de la seconde couche de diélectrique, cette seconde couche de diélectrique et la couche espaceur 133 sont issues d'une seule et même couche 133, continue. Ainsi, dans ce cas de figure, la couche espaceur 133 s'étend de manière continue sur le pourtour des premières grilles et sur la couche 120 de diélectrique. Cette variante de réalisation est plus aisée à réaliser que la variante dans laquelle le diélectrique 121 est constitué de la couche 120 de diélectrique uniquement. En effet, il n'est pas alors pas nécessaire de structurer la couche espaceur 133, une fois celle-ci déposée sur les premières grilles 131 et la couche 120 de diélectrique. Cette variante permet donc de s'affranchir d'une étape de gravure anisotrope de la couche espaceur 133 après son dépôt (puisque cette gravure n'est pas nécessaire). En contrepartie, comme il sera mieux compris par la suite, les deuxièmes grilles 132 sont un peu plus éloignées de la couche semiconductrice 110 et donc des boites quantiques 1151. Le contrôle électrostatique des boites quantiques ainsi que le couplage des détecteurs de charge 140 aux boites quantiques 1151 peut alors être sensiblement moins performant.

**Les deuxièmes grilles 132** sont orientées selon une deuxième direction Y différente de la première direction X. Cette direction Y correspond à la direction des colonnes 115b de boites quantiques 1151 (cf. figure1).

Sur la figure 1, la deuxième direction est ici orientée à 90° par rapport à la première direction X. Naturellement, cette deuxième direction Y peut être orientée d'un angle différent de 90° par rapport à la première direction X.

Chaque deuxième grille 132 s'étend directement sur le diélectrique 121, qui est donc un diélectrique de grille et croise les premières grilles 131 au niveau de zones de croisement (notées I_{G1,G2} sur la figure 1) selon une configuration dite « imbriquée ».

Cette configuration « imbriquée » est décrite en détails ci-après, en relation avec la figure 2.

Selon cette configuration imbriquée, chaque deuxième grille 132 présente une hauteur qui est supérieure à la hauteur des premières grilles 131. De préférence, la hauteur des deuxièmes grilles 132 est supérieure de 20 nm à 50 nm à celle des premières grilles 131. La dimension latérale des deuxièmes grilles est de préférence identique à celle des premières grilles.

De plus chaque deuxième grille 132 s'étend :
- directement sur le diélectrique 121 (sur la figure 2, ce diélectrique 121 est la couche 120 de diélectrique) entre deux premières grilles adjacentes (ou, dit autrement dans les espaces inter-premières grilles), et
- sur la couche espaceur 133 recouvrant les flancs et la face supérieure des premières grilles au niveau des zones de croisement I_{G1,G2} (cf. figures 1 et 2).

En d'autres termes, chaque deuxième grille 132 passe par-dessus, ou chevauche, les premières grilles 131 enrobées de la couche espaceur 133 au niveau des zones de croisement I_{G1,G2}. Ce chevauchement permet de ne pas couper physiquement les premières grilles 131 au niveau des zones de croisement I_{G1,G2}.

Grâce à la couche espaceur 133, qui est interposée entre les premières grilles 131 et les deuxièmes grilles 132, chaque deuxième grille 132 croise les premières grilles 131 sans qu'il y ait un contact électrique avec celles-ci.

De plus, comme la hauteur des deuxièmes grilles 132 est supérieure à celle des premières grilles 131, on obtient, aux zones de croisements I_{G1,G2}, des premières grilles 131 qui sont logées sous des renfoncements isolants des deuxièmes grilles 132.

Ces renfoncements isolants sont visibles sur la figure 2 puisque la coupe transversale illustrée sur cette figure est selon un plan de coupe passant par une deuxième grille 132 au niveau d'une zone de croisement I_{G1,G2}. Ces renfoncements sont notés avec la référence 133_{R} sur la figure 2. Chaque renfoncement 133_{R} forme un pont isolant sous lequel passe une première grille 131.

Comme le montre la figure 2, les renfoncements 133_{R} définissent dans chaque deuxième grille 132 un étage inférieur 136, et un étage supérieur 137 qui sont conducteurs.

L'étage inférieur 136 présente un motif comprenant une pluralité de zones conductrices inférieures 1361 (ces zones conductrices inférieures sont aussi notées 1361-1, 1361-2, 1362-3, 1361-4 sur la figure 2).

Chaque région conductrice inférieure 1361 est séparée des zones conductrices inférieures adjacentes par l'un des renfoncements isolants 133_{R}.

L'étage supérieur 137 forme une région conductrice supérieure continue 137. La configuration imbriquée permet donc de conserver la continuité électrique le long de chaque première grille 131 et le long de chaque deuxième grille 132.

Comme il sera décrit plus loin dans la description, ces zones conductrices inférieures 136 et la région conductrice supérieure 137 sont avantageusement utilisées pour former les détecteurs de charge 140.

Comme le montre la figure 1, la disposition des premières et deuxièmes grilles 131, 132 permet également de définir à la surface du diélectrique (ici la couche 120 de diélectrique) un réseau d'espaces réguliers (aussi notés « mailles bidimensionnelles » par la suite). Chaque maille bidimensionnelle correspond à la zone d'une boite quantique 1151.

Chaque maille bidimensionnelle comprend l'espace de diélectrique libre défini à l'intersection entre deux premières grilles adjacentes et deux deuxièmes grilles adjacentes et le contour fermé formé par les portions des grilles de l'intersection.

Dans l'exemple de la figure 1, les directions X, Y des premières et deuxièmes grilles 131, 132 ici sont orthogonales l'une par rapport à l'autre. Les mailles bidimensionnelles sont de forme carrées.

Les directions X, Y des premières et deuxièmes grilles 131, 132 peuvent alternativement être orientées avec un angle différent de 90°.

Lorsque la couche semiconductrice 110 comporte des trous 117 comme illustré sur la figure 1, les directions X et Y des premières grilles et deuxièmes grilles correspondent aussi, respectivement, aux directions des lignes et des colonnes de trous 117. Les premières et deuxièmes grilles sont, de plus, disposées de sorte qu'il y ait un trou 117 en regard de chaque zone de croisement I_{G1,G2}. Ainsi, un trou 117 est disposé à chaque sommet des mailles bidimensionnelles.

Le contrôle indépendant de chaque première et deuxième grille 131, 132 permet de contrôler électro-statiquement et avec des interactions de courte portée une boite quantique 1151 dans chaque région de la couche semiconductrice 110 située à l'aplomb d'une maille bidimensionnelle.

Ce contrôle est facilité par la présence des trous 117 puisque ceux-ci permettent de confiner (de manière non électrostatique) des charges au niveau des régions de la couche semiconductrice formant les boites quantiques 1151.

Chaque région de la couche semiconductrice 110 formant une boite quantique présente des dimensions latérales, définies dans le plan {X,Y}, qui sont préférentiellement comprises entre 5 nm et 100 nm, et préférentiellement égales à 50 nm. L'épaisseur de la région de la couche semiconductrice 110 formant une boite quantique est par ailleurs préférentiellement comprise entre 5 nm et 30 nm, et préférentiellement égale à 15 nm.

La distance entre deux boites quantiques voisines, c'est-à-dire deux boites quantiques formées en regard de deux mailles bidimensionnelles voisines, est préférentiellement comprise entre 25 nm et 125 nm.

Plus précisément, le contrôle des premières et deuxièmes grilles permet de contrôler par effet de champ la conduction de barrières tunnel 1152a, 1152b situées de part et d'autre (selon les directions X et Y) de chaque maille bidimensionnelle.

Sur la partie de la figure 1 représentant une vue agrandie d'une maille bidimensionnelle, ces barrières tunnel 1152a, 1152b sont représentées par des rectangles en pointillés. Chaque barrière tunnel notée 1152a est ici située en regard d'une deuxième grille 132 et relie la boite quantique 1151_{i,j} à la boite quantique adjacente 1151_{i,j-1} (ou 1151_{i,j+1}) formée sur la même ligne du réseau de mailles bidimensionnelles. Chaque barrière tunnel notée 1152b est ici située en regard d'une première grille 131 et relie la boite quantique 1151_{i,j} à la boite quantique adjacente 1151_{i-1,j} (1151_{i+1,j}) ou formée sur la même colonne du réseau de mailles bidimensionnelles.

Les barrières tunnel 1152a, 1152b présentent préférentiellement des dimensions latérales inférieures à celles des boites quantiques 1151, par exemple des dimensions latérales comprises entre 5 nm et 30 nm. Leur épaisseur est en revanche similaire à celle des boites quantiques 1151.

D'après ce qui précède, les premières grilles 131 sont disposées à l'aplomb de premières barrières tunnel 1152b, et les deuxièmes grilles sont disposées à l'aplomb de deuxièmes barrières tunnels 1152a. Chaque première barrière tunnel 1152b relie deux boites quantiques voisines disposées dans une même colonne 115b de la matrice de boites quantiques, tandis que chaque deuxième barrière tunnel 1152a relie deux boites quantiques voisines disposées dans une même ligne de cette matrice 115.

**Chaque détecteur de charge 140** comporte un îlot quantique conducteur 141 (noté aussi îlot 141 par la suite) et deux réservoirs de charge électriquement indépendants : un drain 142 et une source 143. Il convient de noter que, dans la suite de la description, drain 142 et source 143 sont interchangeables.

Le drain et la source étant indépendants, chaque détecteur de charge 140 peut être mesuré en transport. Une telle mesure est par exemple décrite dans le document « Observation of spin-space quantum transport induced by an atomic quantum point contact » de Koki Ono et al., Nature Communications 12, 2021.

Comme le montrent les figures 2 et 3A à 3C, l'ilot 141 de chaque détecteur de charge 140 est formé entre deux premières grilles 131 adjacentes et directement sur le diélectrique 121,120.

Ainsi, cet îlot 141 est formé au même niveau que celui des premières et deuxièmes grilles 131, 132. Cela permet d'obtenir un dispositif quantique 100 compact (en termes de hauteur). L'expression « au même niveau » signifie que chaque îlot 141 est formé entre la face inférieure des premières grilles et la face supérieure des deuxième grilles.

De plus, comme il sera décrit plus loin dans la description en relation avec le procédé de fabrication, le fait de former les îlots conducteurs 141 entre des premières grilles 131 offre l'avantage de pouvoir utiliser ces premières grilles 131 comme repère d'alignement au moment des étapes de fabrication des îlots conducteurs 141. Dit autrement, les premières grilles permettent d'«auto-aligner» les îlots 141. Cet auto-alignement facilite ces étapes de fabrication.

La compacité et la simplicité de fabrication sont des atouts pour la mise à l'échelle des processeurs quantiques.

De manière commune aux deux variantes de réalisation illustrées respectivement en figure 2 et 4, chaque îlot 141 est formé dans l'une des zones conductrices inférieures 1361 d'une deuxième grille 132. Ces zones conductrices inférieures 1361 sont, comme décrit précédemment, comprises entre deux premières grilles 131.

L'ilot 141 de chaque détecteur de charge 140 est ainsi « posé » sur le diélectrique à l'aplomb d'une barrière tunnel 1152a et est couplé à l'une et l'autre des boites quantiques 1151 disposées, dans le plan de la couche semiconductrice 110, de part et d'autre de cette barrière tunnel 1152a. Ce couplage est matérialisé par des flèches sur la partie de la figure 1 représentant une vue agrandie d'une maille bidimensionnelle. Chaque détecteur de charge 140 est alors partagé entre au moins deux boites quantiques 1151.

Plusieurs îlots 141 sont formés dans une même deuxième grille 132 (cf. figure 2).

Dans cette deuxième grille 132, les zones conductrices inférieures 1361 définissant un îlot 141 sont recouvertes d'une couche barrière 144 (cf. figure 2, en particulier l'insert de gauche de cette figure 2). Cette couche barrière 144 est agencée au sein de la deuxième grille 132. Cette couche barrière 144 a pour effet d'isoler électriquement l'îlot 141 de l'étage conducteur supérieur 137 et des autres îlots 141 de la deuxième grille 132. Elle a aussi pour effet de permettre la formation d'un courant tunnel en son sein.

Tous les détecteurs de charge 140 de cette deuxième grille ont une source 143 commune, formée par l'étage supérieur 137 de cette deuxième grille. La source 143 commune est reliée par couplage tunnel à chaque îlot conducteur 141 grâce à la couche barrière 144.

Enfin, chaque détecteur de charge 140 de cette deuxième grille 132 a un drain 142, formé par un via conducteur 1421 enrobé sur ses flancs d'une couche isolante 1422. Cette couche isolante 1422 est formée d'un matériau isolant. Par exemple, elle formée à base de dioxyde de silicium SiO₂. La couche isolante 1422 de chaque drain 142 est suffisamment large pour isoler la source 143 du drain 142. Par exemple, lorsque la couche isolante 1422 est formée de SiO₂, sa largeur est de 5 nm.

Le via conducteur 1421 enrobé présente une extrémité inférieure 1423 et une extrémité supérieure 1424 opposée. Le via conducteur 1421 enrobé traverse l'étage supérieur 137 jusqu'à la couche barrière 144. Une partie au moins de la couche barrière 144 est au contact de l'extrémité inférieure 1424 du via conducteur 1421.

En utilisant ainsi des régions 1361, 137 de la deuxième grille 132 pour d'une part, former l'îlot conducteur 141 et l'un des réservoirs de charge 143, et, d'autre part, incorporer l'autre réservoir de charge 142, on réduit l'empreinte globale (latérale mais aussi verticale) du détecteur de charge 140 dans le dispositif quantique 100. Cela permet donc d'obtenir un dispositif 100 compact, ce qui est avantageux pour la mise à l'échelle des processeurs quantiques.

L'utilisation, en particulier, la zone conductrice supérieure 137 pour former/incorporer les réservoirs de charge 142, 143 offre un avantage supplémentaire pour intégrer les fonctions d'adressage des détecteurs de charge 140. En effet, cette zone conductrice supérieure 137 est aisément accessible pour une reprise de contact électrique par le haut ou/et pour une reprise de contact électrique aux extrémités des deuxièmes grilles 132.

Le contrôle de la source 143 peut ainsi être effectué sans connectique verticale (de type via) par une extrémité d'une deuxième grille 132 couplée à une source de tension.

La mesure de l'îlot 141 peut être effectuée via l'extrémité supérieure 1424 du via conducteur 1421. Comme le montrent les figures 2 et 4, une ligne de métallisation 146 destinée à polariser les drains d'une même deuxième grille 132 peut s'étendre sur les extrémités supérieures 1424 des vias conducteurs 1421 formés sur cette deuxième grille 132. Dans ce cas, une couche d'encapsulation 147 est interposée entre la ligne de métallisation 146 et la région conductrice supérieure 137. Cette couche d'encapsulation 147 peut être formée du même matériau que la couche 1422 recouvrant les vias conducteurs 1421. On note, sur les figures 2 et 3, la présence d'une couche de masque dur 148 interposée entre la couche d'encapsulation 147 et la région conductrice supérieure 137. Cette couche de masque dur 148 est liée au processus de fabrication.

Présenté autrement, les détecteurs de charges 140 sont disposés tels qu'ils forment des lignes de détecteurs de charges 140 et tels que l'un parmi la source 143 et le drain 142 de chaque détecteur de charges 140 d'une même ligne de détecteurs de charges 140 est en contact électrique avec une même ligne de métallisation 146, et tels que l'autre parmi le drain 142 et la source 143 de chaque détecteur de charges 140 est commun pour chaque détecteur de charges 140 d'une même ligne de détecteurs de charges 140.

Par ailleurs, il est possible que l'ilot conducteur 141 de chaque détecteur de charges 140 soit intégré dans l'une des deuxièmes lignes de grilles 132.

Comme le montrent les figures 2 et 4, le dispositif quantique 100 peut également avantageusement comprendre des grilles 145 pour contrôler le potentiel chimique des îlots 141. Ces grilles 145 sont appelées par la suite « grilles 145 de contrôle des détecteurs de charge ».

Chaque grille 145 de contrôle des détecteurs de charge 140 est logée sous un renfoncement isolant 133_{R}, où elle s'étend sur une première grille 131 recouverte de l'espaceur 133.

Chaque îlot 141 est alors relié à la grille de contrôle 145 des détecteurs de charge par l'intermédiaire des renfoncements 133_{R}.

En interposant ainsi les grilles 145 de contrôle des détecteurs de charge 140 sous les renfoncements 133_{R} des deuxièmes grilles 132, on réduit le nombre d'interconnexions électriques à réaliser pour contrôler les détecteurs de charge 140. Cet espace économisé conduit à un dispositif quantique 100 plus compact que les solutions de l'art antérieur qui utilisent des plans semiconducteurs superposés.

Le nombre d'îlots conducteurs 141 formés dans une même deuxième grille 132 dépend de la structure interne de cette deuxième grille 132.

Selon la première variante de réalisation, illustrée sur la figure 2 et sur la figure 3C, la structure interne de la deuxième grille 132 est d'un premier type permettant de former un îlot 141 dans une région conductrice inférieure 1361 sur deux.

Ce premier type permet également de relier deux îlots conducteurs 141 adjacents à un même drain 142. Ainsi, il y a moins de drains 142 (jusqu'à moitié moins) que de détecteurs de charge 140. Cela permet de réduire le nombre d'éléments à intégrer dans le dispositif quantique 100 pour former les détecteurs de charge 140. Cette réduction du nombre d'éléments contribue à réduire l'empreinte des détecteurs de charge dans le dispositif quantique 100.

Selon ce premier type, la couche barrière 144 comprend une couche barrière inférieure 1441, appelée aussi couche tunnel 1441, et une couche barrière supérieure 1442.

La couche tunnel 1441 recouvre tous les renfoncements 133_{R} au niveau de la face supérieure des premières grilles 131.

Pour des raisons liées à la fabrication du dispositif quantique 100, la couche tunnel 1441 est ici interposée entre la couche isolante 133 (du renfoncement 133_{R}) et une couche de masque dur 1443 (cf. figure 2).

La couche tunnel 1441 présente des caractéristiques permettant de réaliser un couplage tunnel en son sein.

Sur la figure 2, les flèches matérialisent le sens du courant circulant dans chaque ilot 141 d'un transistor à un électron SET.

La dimension latérale de la couche tunnel 1441 correspond à la dimension latérale de la première grille 131. Dans l'exemple d'une première grille de dimension latérale 20 nm, la couche tunnel 1441 est suffisamment étroite pour permettre le passage d'un courant tunnel.

La couche tunnel 1441 peut être formée d'oxyde d'aluminium (Al₂O₃). Alternativement, la couche tunnel 1141 peut être une couche de silicium non dopé.

De préférence, la couche tunnel 1441 est formée à base d'un oxyde d'hafnium (HfO2). Ce matériau présente en effet une résistance programmable à ajuster à une valeur comprise entre quelques kiloohms et quelques dizaines de kiloohms. La couche tunnel 1441 présente alors préférentiellement une épaisseur comprise entre 5 nm et 10 nm.

La couche barrière supérieure 1442 est disposée sur les couches tunnel 1441 de sorte que :
- une région conductrice inférieure 1361-4 sur quatre prolonge la région conductrice supérieure 137 vers le diélectrique 121,120 (Sur la figure 2, les trois régions complémentaires sont notées avec les références 1361-1, 1361-2 et 1361-3), et
- la région conductrice inférieure 1361-2 située au centre des trois régions conductrices inférieures complémentaires soit prolongée par le via traversant 1421,1422 formant le drain 142.

Dans la suite de la description, la région conductrice inférieure 1361-2 située au centre des trois régions conductrices inférieures complémentaires est appelée « région inférieure centrale1361-2 », tandis que les deux régions situées de part et d'autre de cette région centrale sont appelées « régions inférieures latérales 1361-1, 1361-3 ».

La couche barrière supérieure 1442 recouvre ainsi les deux régions inférieures latérales 1361-1, 1361-3.

Sur les deux renfoncements 133_{R} entourant la région inférieure centrale 1361-2, la couche barrière 1442 est au contact de la couche isolante 1422 enrobant le via traversant 1441.

Les régions inférieures latérales 1361-1 et 1361-3, recouvertes de la couche barrière supérieure 1442, forment chacune un îlot conducteur 141.

Le via traversant 1421 et la région inférieure centrale 1361-2 forment une région conductrice continue. Celle-ci forme le drain 142 des deux îlots 141 formés dans les régions inférieures latérales 1361-1 et 1361-3. Le couplage tunnel entre ce drain 142 et les deux îlots 141 est effectué dans chacune des couches tunnel 1441 disposées de part et d'autre de la région conductrice centrale 1361-2.

L'étage supérieur 137 (et la région conductrice inférieure 1361-4 qui se prolonge vers cet étage supérieur 137) forme la source 143 des deux îlots 141 formés dans les régions inférieures latérales 1361-1 et 1361-3. Le couplage tunnel entre la source 143 et les deux îlots 141 est effectué dans chacune des couches tunnel 1441 disposées sur les renfoncements 133 délimitant les trois régions complémentaires.

Sur la figure 2, le couplage tunnel drain-îlot et source-îlot est matérialisé par des flèches.

Comme le montrent les figures 3A à 3C, chaque deuxième grille 132 peut présenter cette structure du premier type. Alternativement, une deuxième grille 132 peut présenter cette structure du premier type.

Les régions conductrices inférieures 1361-1, 1361-3 choisies pour définir les ilots 141 dans une deuxième grille 132 donnée sont préférentiellement décalées par rapport à celles choisies pour une deuxième grille 132 voisine.

De la sorte, et en référence à la figure 1, les ilots 141 sont agencés en quinconce les uns par rapport aux autres dans l'ensemble formé par les deuxièmes grilles 132. En conséquence, les détecteurs de charge 140 sont aussi disposés en quinconce les uns par rapport aux autres. Cet arrangement en quinconce permet de garantir une bonne sensibilité de mesure avec un nombre réduit de détecteurs de charge 140.

Selon la deuxième variante de réalisation, illustrée sur la figure 4, la structure interne de la deuxième grille 132 est d'un deuxième type permettant de former un îlot 141 dans chaque région conductrice inférieure 1361. Ce deuxième type permet ainsi, par rapport au premier type, de doubler le nombre de détecteurs charge 140 formés dans une même deuxième grille 132. Il y a alors autant de détecteurs de charge 140 que de boites quantiques 1151.

En augmentant ainsi le nombre de détecteurs de charge 140, on permet de mesurer chaque boite quantique 1151 au plus près de celle-ci. Cela améliore la sensibilité de la mesure des boites quantiques.

Ce deuxième type permet, aussi, de relier un drain 142 à chaque îlot 141.

Selon ce deuxième type, toutes les régions inférieures 1361 de la deuxième grille 132 sont recouvertes d'une couche barrière 144 formée de la couche tunnel 1441 décrite précédemment.

Ainsi, contrairement à la structure du premier type, la couche tunnel 1441 s'étend à la fois sur les renfoncements 133_{R} (en regard de la face supérieure des premières grilles 131) et au-dessus des régions conductrices inférieures 1361. La couche tunnel 1441 est donc continue.

Les vias conducteurs 1421 enrobés d'une couche isolante 1422 traversent la région supérieure 137 jusqu'à la couche barrière 144.

L'extrémité inférieure 1423 de chaque via conducteur 1421 est disposée sur la couche barrière 144, en partie à l'aplomb d'une région conductrice inférieure 1361 et en partie à l'aplomb d'un renfoncement 133_{R} adjacent à la région conductrice inférieure 1361. La couche isolante 1422 qui enrobe le via conducteur 1421 est en contact avec la couche barrière 144.

Chaque via conducteur 1421 forme le drain 142 d'un îlot 141.

De plus, comme pour la structure du premier type, la zone conductrice supérieure 137 forme la source 143 de l'ensemble des îlots 141 formés dans cette deuxième grille 132.

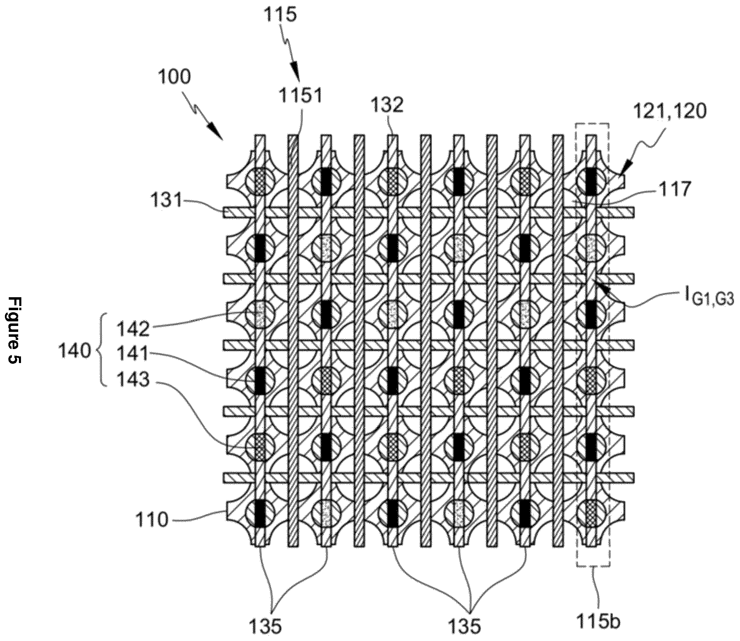

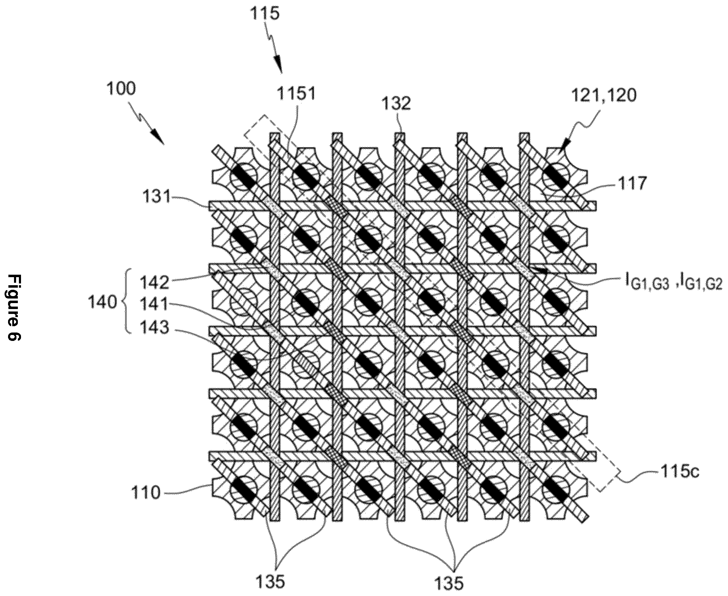

Les figures 5 et 6 montrent un deuxième mode de réalisation du dispositif quantique 100.

Le deuxième mode de réalisation diffère du premier mode de réalisation, illustré en figures 1 à 4, en ce que les détecteurs de charge 140 ne sont pas formés dans les deuxièmes grilles 132 mais dans des troisièmes grilles 135 destinées à contrôler le potentiel chimique des boites quantiques 1151 (c'est-à-dire que ces troisièmes grilles contrôlent le potentiel des détecteurs de charges) et, ainsi, disposées à l'aplomb des boites quantiques 1151.

Cette disposition permet une mesure plus localisée de l'état de charge de la boite quantique 1151 que lorsque le détecteur de charge 140 est à l'aplomb d'une barrière tunnel. En effet, un détecteur de charge 140 disposé à l'aplomb d'une boite quantique est plus sensible à cette dernière car plus proche qu'un détecteur de charge disposé à l'aplomb d'une barrière tunnel. Il est, toutefois, moins sensible aux boites quantiques voisines.

Les deuxièmes grilles 132 sont alors recouvertes, sur leurs flancs et leur face supérieure, d'une couche de matériau isolant formant un espaceur analogue à l'espaceur 133. L'espaceur 133 permet alors d'isoler électriquement les deuxièmes grilles 132 des troisièmes grilles 135.

Les troisièmes grilles 135 sont des bandes conductrices formées à base d'un matériau conducteur similaire à celui formant les premières et deuxièmes grilles 131, 132.

Comme le montrent les figures 5 et 6, ces troisièmes grilles 135 sont distinctes des deuxièmes grilles 132 et sont toutes orientées dans une direction différente de la première direction X des premières grilles 131. De plus, les troisièmes grilles 135 et s'étendent à l'aplomb des boites quantiques 1151.

La figure 5 montre une première variante de réalisation du deuxième mode de réalisation. Selon cette première variante, les troisièmes grilles 135 sont orientées à 90° par rapport aux premières grilles 131. De plus, chaque troisième grille 135 est disposée entre deux deuxièmes grilles 132 adjacentes, à l'aplomb des boites quantiques 1151 disposées sur une même colonne 115b de la matrice 115 de boites quantiques.

Les troisièmes grilles 135 s'étendent directement sur le diélectrique (ici la couche 120 de diélectrique) et croisent les premières grilles 131 (cf. figure 5) selon une configuration imbriquée analogue à la configuration imbriquée décrite précédemment (en relation avec les deuxièmes grilles 132). Les zones de croisement entre les premières grilles et les troisièmes grilles sont notées avec la référence I_{G1,G3} sur les figures 5 et 6.

Ainsi, chaque troisième grille 135 s'étend directement sur le diélectrique entre deux premières grilles 131 adjacentes (ou, dit autrement dans les espaces inter-premières grilles), et passe par-dessus, ou chevauche, les premières grilles 131 enrobées de la couche espaceur 133 au niveau des zones de croisement I_{G1,G3}.

La hauteur des troisièmes grilles 135 est supérieure à celle des deuxièmes grilles 132. De préférence, cette hauteur des troisièmes grilles est supérieure de 20 nm à 50 nm à celle des deuxièmes grilles 132.

Cette configuration imbriquée permet de définir une structure en deux étages (un étage supérieur conducteur continu et un étage inférieur formé d'une pluralité de régions conductrice inférieures) analogue à la structure des deuxièmes grilles 132 du premier mode de réalisation.

Cette configuration imbriquée permet, ainsi, de former dans chaque troisième grille 135, ou dans une troisième grille 135 sur deux, la structure interne décrite précédemment en relation avec le premier mode de réalisation.

Dans l'exemple montré sur la figure 5, chaque troisième grille 135 présente la structure interne du premier type, illustrée en figure 2.

Ainsi, dans ces troisièmes grilles 135, une région conductrice inférieure 1361 sur deux forme un îlot conducteur 141. De plus, la région conductrice supérieure 137 forme la source commune de tous les îlots formés dans la troisième grille, et des vias conducteurs enrobés de la couche isolante forme les drains 142.

Cette configuration permet de positionner les îlots conducteurs à l'aplomb des boites quantiques (à la différence du premier mode de réalisation, où les îlots 141 sont à l'aplomb des barrières tunnel).

Comme dans le premier mode de réalisation, les îlots 141 sont disposés en quinconce les uns par rapport aux autres.

Naturellement, les troisièmes grilles 135 peuvent alternativement présenter la structure du deuxième type, illustrée en figure 4. Dans ce cas, dans les troisièmes grilles 135, chaque région conductrice inférieure 1361 forme un îlot conducteur 141. Un détecteur de charge 140 est alors disposé à l'aplomb de chaque boite quantique 1151.

La figure 6 montre une deuxième variante de réalisation du deuxième mode de réalisation. Selon cette deuxième variante, les troisièmes grilles sont orientées à 45° par rapport aux premières et aux deuxièmes grilles 131, 132. Chaque troisième grille 135 s'étend à l'aplomb des boites quantiques disposées sur une même diagonale 115c de la matrice 115 de boites quantiques.

Les troisièmes grilles 135 s'étendent directement sur le diélectrique (ici la couche 120 de diélectrique) et croisent les premières et les deuxièmes grilles 131, 132 selon la même configuration imbriquée que celle décrite en relation avec la première variante de réalisation.

Les zones de croisement entre les premières grilles et les troisièmes grilles I_{G1,G3} correspondent aux zones de croisement entre les premières et les deuxièmes grilles I_{G1,G2}.

Dans l'exemple montré sur la figure 6, chaque troisième grille 135 présente la structure interne du deuxième type, illustrée en figure 4.

Ainsi, dans ces troisièmes grilles 135, chaque région conductrice inférieure 1361 forme un îlot conducteur 141. De plus, la région conductrice supérieure 137 forme la source commune de tous les îlots formés dans la troisième grille, et des vias conducteurs enrobés de la couche isolante forment les drains 142.

Cette configuration permet de positionner un îlot conducteur 141 à l'aplomb de chaque boite quantique 1151.

Naturellement, les troisièmes grilles 135 peuvent alternativement présenter la structure du premier type, illustrée en figure 5. Dans ce cas, dans les troisièmes grilles 135, une région conductrice inférieure 1361 sur deux forme un îlot conducteur 141. Un détecteur de charge 140 est alors partagé entre deux boites quantiques 1151.

D'après ce qui précède, le dispositif quantique 100 comprend deux ensembles de grilles de contrôle des boites quantiques 1151 : le premier ensemble comporte les premières grilles 131; le deuxième ensemble comporte des grilles qui s'étendent sur le diélectrique 120 et croisent les premières grilles 132. Le deuxième ensemble comporte, au moins, les deuxièmes grilles 132.

De plus, l'îlot conducteur 141 de chaque détecteur de charge 140 est formé par une région de l'une des grilles du deuxième ensemble, ladite région étant comprise entre deux premières grilles 131 adjacentes et disposée directement sur le diélectrique 120.

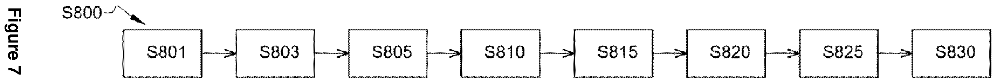

La figure 7 montre une représentation schématique d'un schéma synoptique d'un procédé 800 de fabrication du dispositif quantique 100 illustré en figure 2.

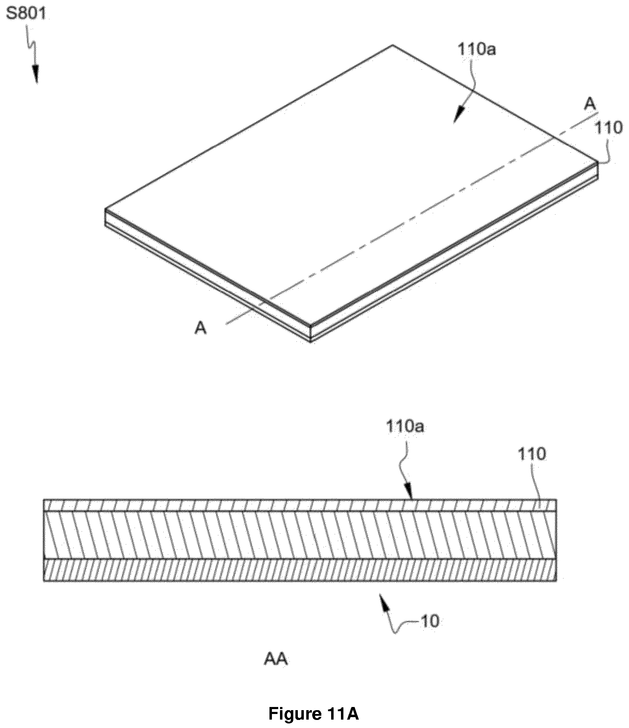

Les figures 11A à 11L sont des représentations schématiques en perspective et en vue de coupe illustrant certaines étapes ou sous-étapes du procédé de fabrication 800.

Le procédé de fabrication 800 débute par une première étape S801 de fourniture du substrat, par exemple du substrat SOI 10. Ce substrat 10 comprend sur sa face avant 110a la couche semiconductrice 110. Cette première étape S801 est illustrée sur la figure 11A.

En référence à la figure 7, cette étape S801 est suivie d'une étape S803 (de définition de l'agencement de la matrice 115 de boites quantiques 1151 et des barrières tunnel 1152a, 1152b dans la couche semiconductrice 110. Dit autrement, cette étape S803 consiste à déterminer les régions de la couche semiconductrice 110 dans lesquelles seront formées les boites quantiques 1151, ainsi que les régions dans lesquelles seront formées les barrières tunnel 1152a, 1152b.

En référence à la figure 7, le procédé 800 se poursuit avec une étape S805 de dépôt d'une première couche diélectrique 120 destinée à former le diélectrique 120 du dispositif 100 (représenté sur la figure 2) sur la totalité de la face avant 110a de la couche semiconductrice 110.

Cette troisième étape S805 est suivie d'une quatrième étape S810 visant à réaliser conjointement les premières grilles 131, les grilles 135 de contrôle des détecteurs de charge 140 et la couche tunnel 1441 (cf. figure 2).

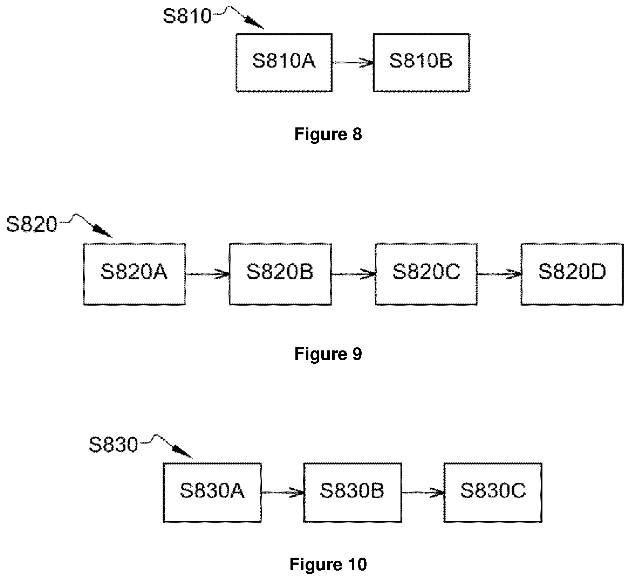

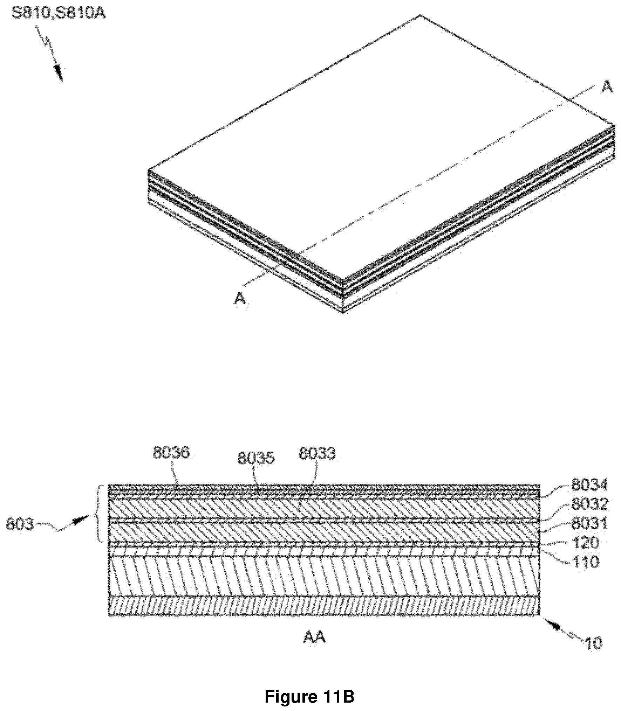

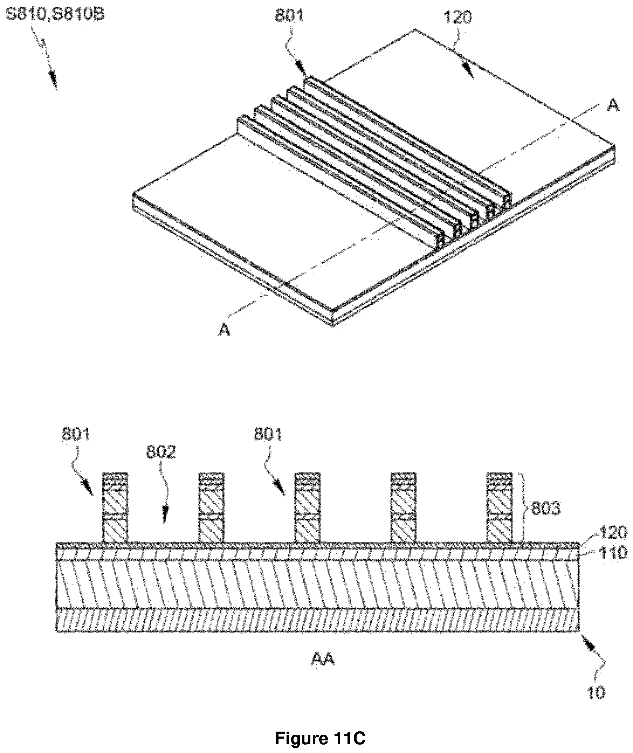

En référence à la figure 8, cette étape S810 comporte les sous-étapes successives S810A et S810B. Ces sous-étapes sont également illustrées en figure 11B et 11C.

En référence à la figure 11B, la sous-étape S810A est une sous-étape de formation d'un premier empilement 803 sur toute la surface du diélectrique 120, par :
- Dépôt, sur la couche de diélectrique 120, d'une première couche conductrice 8031 réalisée avec le matériau conducteur destiné à former les premières grilles 131,
- Dépôt, sur la première couche conductrice 8031, d'une deuxième couche de diélectrique 8032 réalisée avec le matériau diélectrique formant l'espaceur 133. Cette deuxième couche de diélectrique 8032 forme une isolation électrique entre la première couche conductrice et la couche conductrice suivante.
- Dépôt, sur la deuxième couche de diélectrique 8032, d'une troisième couche conductrice 8033 réalisée avec le matériau conducteur destiné à former les grilles 135 de contrôle des détecteurs de charge 140,
- Dépôt, sur la troisième couche conductrice 8033, d'une quatrième couche de diélectrique 8034. Cette quatrième couche diélectrique 8034 est formée avec le matériau de l'espaceur 133. Elle est destinée à former la partie supérieure des renfoncements isolants 133_{R} (cf. figure 2),
- Dépôt, sur la quatrième couche de diélectrique 8034, d'une cinquième couche 8035 de diélectrique réalisée avec le matériau diélectrique destiné à former la couche tunnel 1441 des détecteurs de charge 140,
- Dépôt, sur la cinquième couche de diélectrique 8035, d'une couche 8036 d'un matériau de masque dur. Ce masque dur est par exemple formé à base de nitrure de silicium (SiN). Cette couche de masque dur est notée par la suite « premier masque dur 8036 ».

En référence à la figure 11C, la sous-étape S810B est une sous-étape de structuration en trois dimensions du premier empilement 803 pour former des premières bandes 801 parallèles les unes aux autres, disposées sur le diélectrique 120 de part et d'autre des régions définies pour les boites quantiques 1151. Précisément, les premières bandes 801 sont disposées en regard des régions définies pour les barrières tunnel 1152a reliant deux boites quantiques adjacentes d'une même ligne 115a de la matrice 115 de boites quantiques.

La sous-étape de structuration S810B est réalisée par gravures successives du premier masque dur 8036 et des couches 8035, 8034, 8033 et 8032, et 8031 avec arrêt sur le diélectrique 120.

Dans chaque première bande 801 ainsi formée, la première couche conductrice 8031 forme l'une des premières grilles131 et la deuxième couche conductrice 8033 forme l'une grille 135 de contrôle des détecteurs de charge 140. La deuxième couche conductrice 8032 réalise quant à elle l'isolation entre ces grilles 131,135.

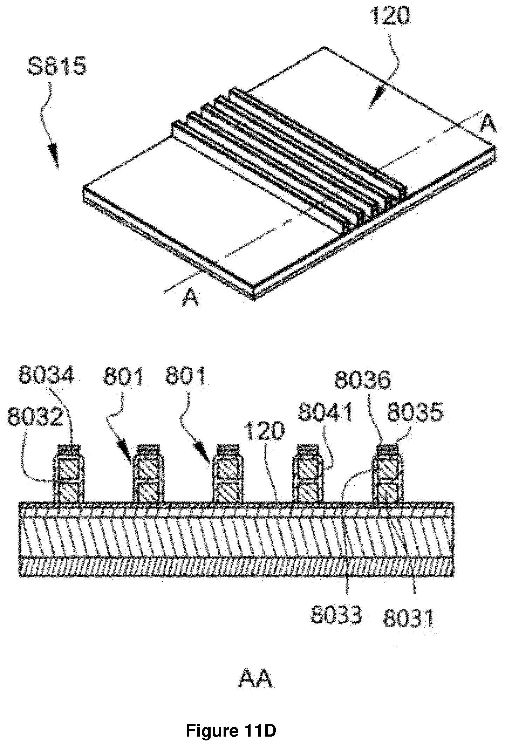

L'étape S810 est suivie d'une cinquième étape S815, illustrée en figure 11D, consistant à réaliser un dépôt conforme d'une couche d'encapsulation 8041 sur les flancs des premières bandes 801. Cette couche d'encapsulation 8041 est réalisé avec le matériau formant l'espaceur 133.

Une gravure anisotrope est ensuite mise en oeuvre afin d'éliminer la couche d'encapsulation 8041 déposée sur au moins une partie des flancs des cinquièmes couches de diélectrique 8035. Ainsi, une partie au moins des flancs de la cinquième couche 8035 est accessible tandis que les autres couches 8034, 8033, 8032 et 8031 sont recouvertes, sur leurs flancs, de la couche d'encapsulation 8041. La gravure anisotrope est en outre configurée pour éliminer la couche d'encapsulation 8041 déposée la couche diélectrique 120 entre les premières bandes 801.

A l'issue de cette étape S815, les renfoncements isolants 133_{R} des deuxièmes grilles 132 sont préparés.

Le procédé 800 se prolonge avec une sixième étape S820 dont le but est de former conjointement les premières grilles 131 et les îlots 141 des détecteurs de charge 140.

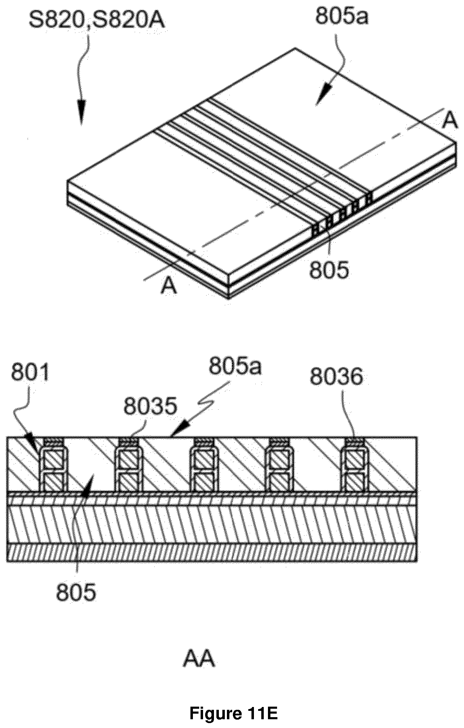

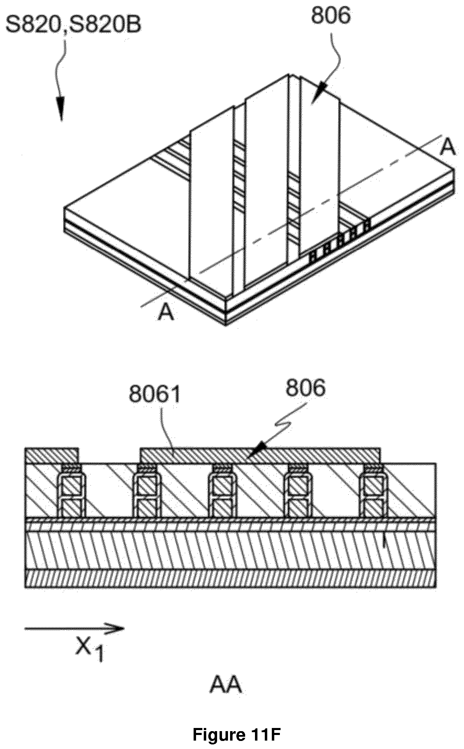

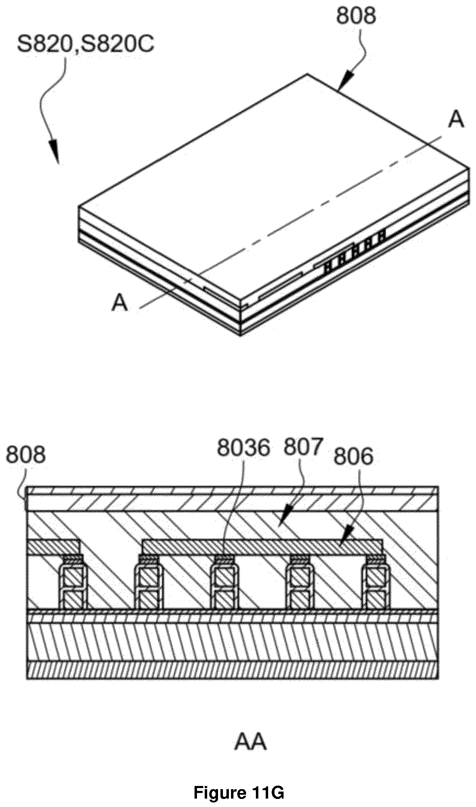

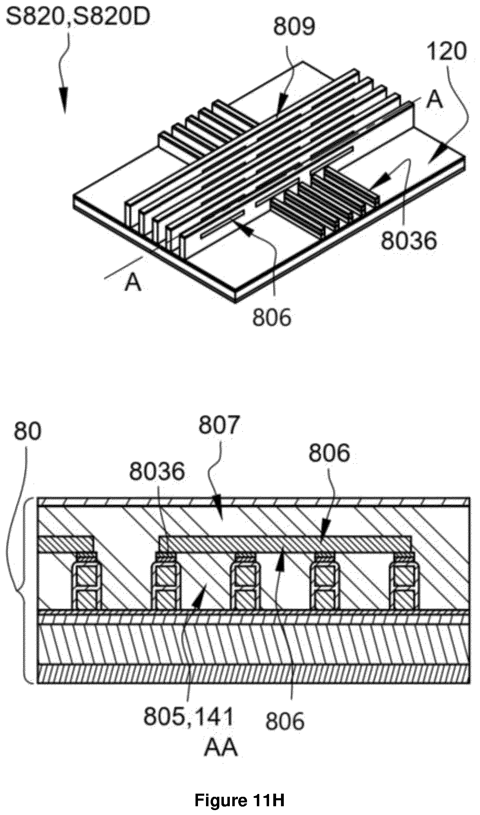

En référence à la figure 9, l'étape S820 comporte préférentiellement les sous-étapes S820A, S820B, S820C et S820D illustrées respectivement sur les figures 11E, 11F, 11G et 11H.

En référence à la figure 11E, la sous-étape S820A consiste à former des bandes conductrices inférieures 805 en remplissant avec le matériau conducteur destiné à former les deuxièmes grilles 132 les zones 802 (cf. figure 11C) du diélectrique 120 situées entre les premières bandes 801. Le remplissage est réalisé jusqu'à hauteur de la couche de masque dur 8036. Les cinquièmes couches de diélectrique 8035 sont ainsi noyées, et donc intégrées, dans ces bandes conductrices inférieures 805.

Ainsi, à l'issue de cette première sous-étape S820A, les régions conductrices inférieures 1361 des deuxièmes grilles 131 sont réalisées. De plus, la couche tunnel 1441 de chaque détecteur de charge 140 a été formée (par la cinquième couche 8035). Chaque région conductrice inférieure 1361 réalisée est ainsi préparée pour former un îlot 141 d'un détecteur de charge 140.

On note que les premières bandes 801 fournissent avantageusement un repère d'alignement pour former les îlots 141. Dit autrement, les îlots 141 sont définis de manière auto-alignée dans les espaces inter-premières grilles, grâce aux premières bandes 801 et à cette étape S820. Cet auto-alignement évite le recours à des étapes de lithographie.

La deuxième sous-étape S820B, illustrée en figure 11F, consiste à déposer une couche 8061 du matériau destiné à former la couche barrière supérieure 1442 sur la surface 805a (cf. figure 11E) formée par la totalité des bandes conductrices inférieures 805 et des couches de masque dur 8036. Ce dépôt est suivi d'une opération de structuration en trois dimensions de cette couche 8061 pour former des bandes 806. En référence à la figure 11F, ces bandes de couche barrière supérieure 806 sont préférentiellement parallèles les unes aux autres et orientées à 45° par rapport aux premières bandes 801. En outre, dans une direction X1 perpendiculaire aux premières bandes 801, chaque bande de couche barrière supérieure 806 recouvre trois bandes conductrices inférieures 805 ainsi que les quatre premières bandes 801 complémentaires. Chaque bande de couche barrière supérieure 806 est par ailleurs séparée des bandes de couche barrière supérieure 806 adjacentes par un espace correspondant à une bande conductrice inférieure 805.

L'orientation des bandes de couche barrière supérieure 806 permet de réaliser la périodicité souhaitée des détecteurs de charge 140 dans le dispositif quantique 100. Ici, l'orientation à 45° permet de réaliser la périodicité d'un ilot 141 formé dans une région conductrice inférieure 1361 sur deux (c'est-à-dire d'8un détecteur de charge 140 pour deux boites quantiques 1151).

La troisième sous-étape S820C, illustrée en figure 11G, consiste d'abord à déposer le matériau conducteur destiné à former les deuxièmes grilles 132 sur la totalité des bandes diélectriques 806 et des bandes conductrices inférieures 805. Ce matériau est identique au matériau des bandes inférieures 805. A l'issue de cette étape S820C, le dispositif est ainsi recouvert d'une couche conductrice 807 qui sera utilisée pour former l'étage conducteur supérieur 137 des deuxièmes grilles 132.

Cette opération de dépôt est suivie d'une opération de planarisation de la couche conductrice supérieure 807.

L'opération de planarisation se prolonge ensuite par une opération de dépôt, sur la couche conductrice supérieure planarisée 807, d'une couche de masque dur 808.

La quatrième sous-étape S820D, illustrée en figure 11H, consiste à structurer l'empilement 80 formé par les bandes conductrices inférieures 805 et la couche conductrice supérieure 807 pour former les premières et les deuxièmes grilles 131, 132.

Cette structuration comprend la définition d'un masque de gravure dans la deuxième couche de masque dur 808 (cf. figure 11G).

Le masque de gravure définit des bandes correspondant aux premières bandes 801 et des deuxièmes bandes 809 parallèles les unes aux autres et orientées perpendiculairement aux premières bandes 801.

Une gravure de l'empilement 80 à travers le masque de gravure est alors mise en oeuvre. La gravure s'arrête sur la couche diélectrique 120 (entre les premières bandes 801) et sur la couche de masque dur 8036 sur les premières bandes 801.

A l'issue de cette étape S820, les premières et deuxièmes grilles 131, 132 sont formées selon la configuration imbriquée décrite en relation avec le premier mode de réalisation, et chaque deuxième grille 132 forme une pluralité d'îlots 141 de détecteurs de charge 140 (dans les régions correspondant aux bandes conductrices inférieures 805) et une source 143 commune (dans la région correspondant à la couche conductrice supérieure 807).

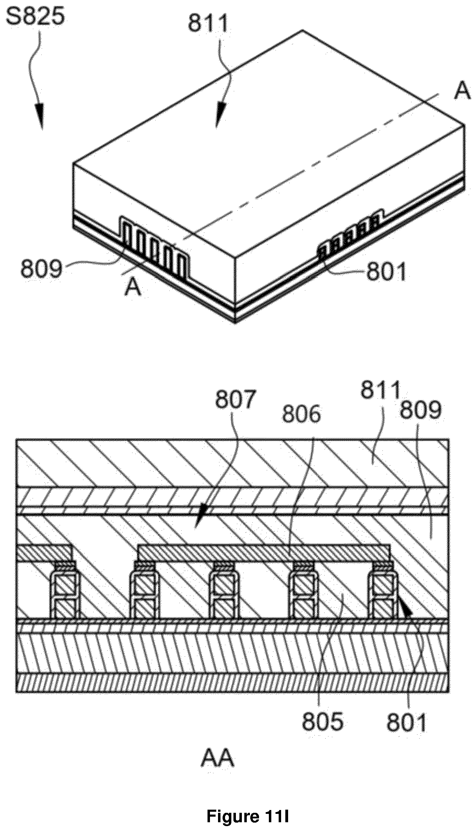

L'étape S820 se poursuit de manière préférentielle avec une étape S825, illustrée en figure 11I, de formation d'une couche d'encapsulation 811, par exemple par dépôt d'une couche diélectrique PMD (acronyme de « Pre-metal Déposition » en anglais) sur le diélectrique 120 de sorte à noyer les premières bandes 801 et les deuxièmes bandes 809.

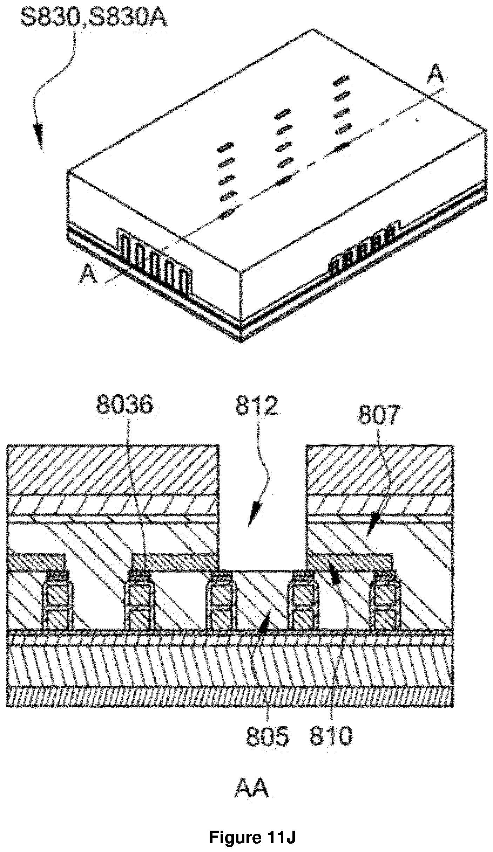

L'étape S825 se prolonge par l'étape S830 consistant à former les drains 142 (ou les sources 143) des détecteurs de charge 140. Cette étape S830 comprend les sous-étapes S830A, S8030Bet S830C illustrées sur les figures 11J à 11L.

La sous-étape S830A, illustrée en figure 11J, consiste à réaliser des ouvertures 812 à travers la couche d'encapsulation 811 (si l'étape S825 d'encapsulation est réalisée) et à travers les deuxièmes bandes 809 de sorte que chaque ouverture 812 débouche dans la bande conductrice inférieure 805 disposée au centre des trois bandes conductrices inférieures recouvertes par la couche barrière supérieure 806.

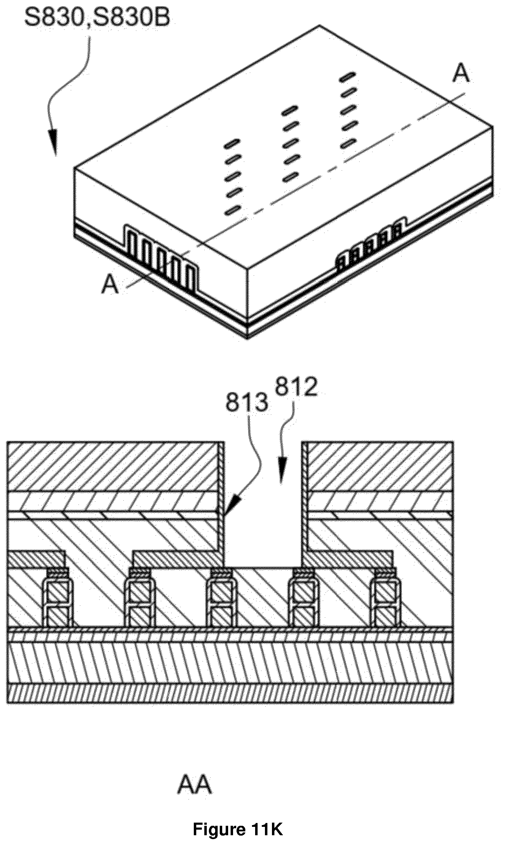

La sous-étape S830B, illustrée en figure 11K, consiste à déposer, de manière conforme et sur les parois latérales des ouvertures 812, une couche 813 du matériau formant la couche isolante 1422 enrobant les vias conducteurs 1421 (formant les drains 142). Cette couche isolante 813 forme une isolation entre la bande conductrice supérieure 807 et le volume intérieur de l'ouverture 812.

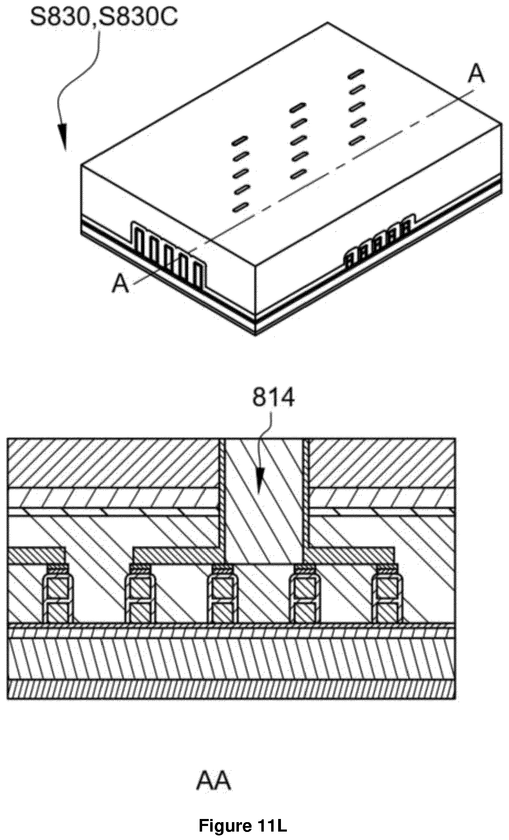

La sous-étape S830C, illustrée en figure 11L, consiste à remplir les ouvertures 812 du matériau conducteur destiné à former les drains ou les sources 142,143 des détecteurs de charges 140.

Les ouvertures 812 ainsi isolées et remplies forment les via conducteurs traversant 814, enrobés d'isolant qui définissent les drains 142 (ou les sources 143) des détecteurs de charge 140.

## Revendications

1. Dispositif quantique (100) comprenant :
- Une couche semiconductrice (110) adaptée pour former une matrice bidimensionnelle (115) de boites quantiques (1151), la couche semiconductrice (110) présentant une face avant (110a),
- un diélectrique (121), disposé sur la face avant (110a) de la couche semiconductrice (110),
- Des premières lignes de grilles (131) et des deuxièmes lignes de grilles (132) pour contrôler les boîtes quantiques (1151), les premières lignes grilles (131) et les deuxièmes lignes de grilles (132) s'étendant directement sur le diélectrique (121), chaque deuxième ligne de grilles (132) croisant les premières lignes de grilles (131), les premières et deuxièmes lignes de grilles (131, 132) définissant un réseau de mailles bidimensionnelles, chaque maille bidimensionnelle étant en regard d'une boite quantique (1151), les premières lignes de grilles et les deuxièmes lignes de grilles étant des lignes de grilles de couplage,
- Des détecteurs de charges (140), chaque détecteur de charge (140) comprenant un ilot conducteur (141), une source (143) et un drain (142),
l'ilot conducteur (141) de chaque détecteur de charge (140) étant formé au niveau d'une maille bidimensionnelle, entre deux premières lignes de grilles (131) adjacentes et directement sur le diélectrique (121), les détecteurs de charges (140) formant des lignes de détecteurs de charges (140) tels que l'un parmi la source (143) et le drain (142) de chaque détecteur de charges (140) d'une même ligne de détecteurs de charges (140) est en contact électrique avec une même ligne de métallisation (146), et l'autre parmi le drain (142) et tels que la source (143) de chaque détecteur de charges (140) est commun pour chaque détecteur de charges (140) d'une même ligne de détecteurs de charges (140).

2. Dispositif quantique (150) selon la revendication 1, dans lequel l'ilot conducteur (141) de chaque détecteur de charges (140) est intégré dans l'une des deuxièmes lignes de grilles (132)

3. Dispositif quantique (100) selon l'une des revendications 1 à 2, dans lequel le drain (142) de chaque détecteur de charge (140) comprend un via conducteur (1421) enrobé d'un matériau électriquement isolant (1422), le via conducteur enrobé (1421) présentant une extrémité (1423) disposée au contact d'une couche barrière (144) disposée à l'aplomb de l'îlot conducteur (141) dudit détecteur de charge (140).

4. Dispositif quantique (100) selon l'une des revendications précédentes, dans lequel l'ilot conducteur (141) de chaque détecteur de charge (140) est formé dans une ligne de grilles (132, 135) de contrôle des boites quantiques (1151) distincte des premières lignes de grilles (131), ladite ligne de grilles (132, 135) croisant les premières lignes de grilles (131) et s'étendant directement sur le diélectrique (121), ladite ligne de grilles (132, 135) présentant des renfoncements (133_{R}) recouverts d'une couche électriquement isolante, les renfoncements (133_{R}) isolants étant disposés aux croisements (I_{G1,G2}, I_{G1,G3}) de ladite ligne de grilles (132, 135) avec les premières lignes de grilles (131), chaque renfoncement isolant (133_{R}) abritant une première ligne de grilles (131), les renfoncements (133_{R}) isolants définissant, dans ladite ligne de grilles (132,135), une pluralité de régions conductrices inférieures (1361) s'étendant directement sur le diélectrique (120), et une région conductrice supérieure (137) continue.

5. Dispositif quantique (100) selon la revendication 4, dans lequel ladite ligne de grilles est l'une des deuxièmes lignes de grilles (132).

6. Dispositif quantique (100) selon la revendication 4, dans lequel ladite ligne de grilles est une troisième ligne de grilles (135) d'un ensemble de troisièmes lignes de grilles (135) destinées à contrôler le potentiel chimique des boites quantiques (1151), chaque troisième ligne de grilles (135) étant disposée à l'aplomb des boites quantiques (1151) formées le long d'une colonne (115b) ou d'une diagonale (115c) de la matrice (115) de boites quantiques, les troisièmes lignes de grilles contrôlant le potentiel des détecteurs de charges (140).

7. Dispositif quantique (100) selon l'une des revendications 4 à 6, dans lequel ladite ligne de grilles présente une structure interne d'un premier type comprenant :
- une couche tunnel (1441) recouvrant chaque renfoncement (133_{R}) isolant de ladite ligne de grilles,
- une région conductrice inférieure (1361-4) sur quatre prolongeant la région conductrice supérieure (137) vers le diélectrique (121), ladite région conductrice inférieure sur quatre (1361-4) définissant trois régions inférieures complémentaires (1361-1, 1361-2, 1361-3),
- les deux régions conductrices inférieures (1361-1, 1361-3) situées aux extrémités des trois régions inférieures complémentaires étant recouvertes d'une couche barrière supérieure (1442), la couche barrière supérieure (1442) étant disposée en partie sur les couches tunnel (1441),
- la région conductrice inférieure (1361-3) située au centre des trois régions inférieures complémentaires étant prolongée par un via conducteur (1421) enrobé d'un matériau électriquement isolant (1422), ledit via conducteur enrobé (1421,1422) traversant la région conductrice supérieure (137) jusqu'à la couche barrière supérieure (1442).

8. Dispositif quantique (100) selon l'une des revendications 4 à 6, dans lequel la structure interne de ladite deuxième ligne de grilles est d'un deuxième type comprenant :
- une couche barrière (144) recouvrant toutes les régions conductrices inférieures (1361) de ladite ligne de grilles, la couche barrière étant continue et disposée sur les renfoncements (133_{R}) isolants de ladite ligne de grilles,
- Des vias conducteurs (1421) enrobés d'un matériau électriquement isolant (1422) traversant la région conductrice supérieure (137) jusqu'à la couche barrière (144), chaque via conducteur présentant une extrémité (1423) disposée, pour une partie, à l'aplomb d'une région conductrice inférieure 1361, et pour l'autre partie, à l'aplomb d'un des renfoncements (133_{R}) isolant adjacent à ladite région conductrice inférieure (1361).

9. Dispositif quantique (100) selon les revendications 5 à 8, dans lequel le dispositif quantique (100) comprend des lignes de grilles (145) de contrôle des potentiels chimiques des ilots conducteurs (141), chaque ligne de grilles (145) de contrôle des potentiels chimiques s'étendant sur une des premières lignes de grilles (131) et étant logée sous les renfoncements (133_{R}) isolants des deuxièmes lignes de grilles au niveau des croisements des premières et deuxièmes lignes de grilles.

10. Dispositif quantique (100) selon les revendications 1 à 9, dans lequel la couche semiconductrice (110) comprend des trous (117) pour former les boites quantiques (1151).

11. Procédé de fabrication (8) d'un dispositif quantique (100) comprenant des détecteurs de charge (140), chaque détecteur de charge (140) comprenant un îlot conducteur (141), un drain (142) et une source (143), le procédé (8) comprenant les étapes suivantes :
- Fourniture (S801, S810) d'une couche semiconductrice adaptée pour former une matrice bidimensionnelle (115) de boites quantiques (1151), ladite couche semiconductrice (110) présentant une face avant (110a), ladite couche semiconductrice (110) comprenant un diélectrique (120) disposé sur la face avant (110a) et des premières lignes de grilles (131) pour contrôler les boites quantiques (1151), les premières lignes de grilles (131) s'étendant directement sur le diélectrique (120), les premières lignes de grilles (131) étant des lignes de grilles de couplage,
- Enrobage (S815) des flancs et de la face supérieure de chaque première ligne de grilles (131) pour loger chaque première ligne de grilles (131) sous un renfoncement isolant (133_{R}),
- Définition (S820A, S820B, S820C) des îlots conducteurs (141) à partir des premières lignes de grilles enrobées, chaque ilot conducteur (141) s'étendant entre deux premières lignes de grilles (131) adjacentes et directement sur le diélectrique (120),
- Formation (S820D), à partir des îlots conducteurs (141) définis, de deuxièmes lignes de grilles (132) pour contrôler, avec les premières lignes de grilles, les boites quantiques, chaque deuxième ligne de grilles s'étendant directement sur le diélectrique (120) et croisant les premières lignes de grilles (131), les premières et deuxièmes lignes de grilles (131, 132) formant un réseau de mailles bidimensionnelles sur le diélectrique (120), les deuxièmes lignes de grilles (132) étant des lignes de grilles de couplage, les détecteurs de charges (140) formant des lignes de détecteurs de charges (140) tels que l'un parmi une source (143) et un drain (142) de chaque détecteur de charges (140) d'une même ligne de détecteurs de charges (140) est en contact électrique avec une même ligne de métallisation (146), et tels que l'autre parmi le drain (142) et la source (143) de chaque détecteur de charges (140) est commun pour chaque détecteur de charges (140) d'une même ligne de détecteurs de charges (140).

12. Procédé de fabrication selon la revendication 11, dans lequel l'étape (S820A, S820B, S820C) de définition des îlots conducteurs comprend les sous-étapes suivantes :
- Remplissage (S820A) avec un matériau conducteur des espaces (805) du diélectrique délimités par deux premières lignes de grilles adjacentes enrobées, le remplissage s'arrêtant à la hauteur des renfoncements isolants,
- Formation (S820B) d'une couche barrière (8061) sur toute la surface obtenue après le remplissage (S820A),
- Structuration (S820C) de la couche barrière pour former des bandes barrières (806) orientées avec un angle prédéterminé par rapport aux premières lignes de grilles.

13. Procédé de fabrication (8) selon la revendication 12, dans lequel l'angle prédéterminé est tel que les bandes barrières sont orientées à 45° par rapport à la direction des premières lignes de grilles, les bandes barrières s'étendant, dans la direction perpendiculaire aux premières lignes de grilles, sur quatre bandes conductrices adjacentes.

14. Procédé de fabrication (8) selon les revendications 10 à 13, comprenant, après l'étape (S820D) de formation des deuxièmes lignes de grilles, une étape (S830) de réalisation de vias conducteurs enrobés d'un matériau électriquement isolant, chaque via conducteur traversant une région supérieure d'une des deuxièmes lignes de grilles avec arrêt sur une région d'une bande diélectrique barrière, le via conducteur formant le drain de l'ilot conducteur défini à l'aplomb de la région de la bande barrière.
